# EUROPEAN PATENT APPLICATION

(11) **EP 4 024 688 A2**
(43) Date of publication of application: **06.07.2022**
(21) Application number: 22150308.9
(22) Date of filing: 05.01.2022
(51) Int. Cl.: H02M 1/12, H02J 3/38, H02M 7/00

(54) **COUPLING OF POWER ELECTRIC DEVICES**

(30) Priority: 05.01.2021 US 202117141709
(71) Applicant: SolarEdge Technologies Ltd., 4673335 Herzeliya (IL)
(72) Inventor: TOSCOVICH, Ilan, 4673335 Herzeliya (IL); GLOVINSKY, Tzachi, 4673335 Herzeliya (IL); BIEBER, Ofir, 4673335 Herzeliya (IL)
(74) Representative: V.O.

(57) **Abstract**

Methods for deploying connected power devices (102) and systems of connected power devices prior to deployment in a photovoltaic installation are described. For example, a string of power devices pre-coupled by conductors (220) is disclosed, which saves cost, provides convenient storage (400), reduces electromagnetic interference, and is easy to deploy.

## Description

### CROSS REFERENCE TO RELATED APPLICATIONS

This application claims the benefit and is a continuation-in-part of U. S. Application Serial No. 15/593,761 filed May 12, 2017. This application further claims benefit and is a continuation-in-part of U.S. Application Serial No. 15/478,526 filed April 4, 2017, and claims benefit to U.S. Provisional Patent Application No. 62/318,303 filed April 5, 2016, U.S. Provisional Patent Application No. 62/341,147 filed May 25, 2016, and U.S. Provisional Patent Application No. 62/395,461 filed September 16, 2016. The contents of the above identified applications are incorporated herein by reference in their entireties.

### BACKGROUND

Power devices may be electrically coupled or electrically connected to photovoltaic (PV) generators and configured to set the operating point of the generators to generate maximum power. They may also be coupled to power production and/or storage units such as batteries, wind or hydroelectric turbines and the like.

Power devices are often manufactured, packaged and sold as single units, leading to deployment which requires that each device be individually coupled to its power unit and the devices themselves coupled by connecting electric cables between them.

Accordingly, there is a need for power device systems in which costs, time and complexity in deploying the power devices are reduced.

### SUMMARY

The following summary is a short summary of some of the inventive concepts for illustrative purposes only, and is not intended to limit or constrain the inventions and examples in the detailed description. One skilled in the art will recognize other novel combinations and features from the detailed description.

Variations herein may employ a string of photovoltaic power devices (e.g. DC/DC converters, DC/AC inverters, measuring and monitoring devices) which may be deployed in photovoltaic installations. In some variations discussed herein, conductors may be used to couple power devices to one another during manufacturing to form a chain of power devices, with the chain packaged and sold as a single unit. A single chain or string of power devices may have power devices alternating with conductors so that each pair of adjacent power devices are permanently connected (e.g., prefabricated, designed to not be disconnected in the field during installation of the system, bonded by soldering or crimping, etc.) with a different one of the conductors. The chain may be deployed by coupling the power devices in the chain to photovoltaic (PV) generators (e.g. one or more photovoltaic cells, substrings, PV panels, strings of PV panels and/or PV shingles). The coupling of power devices at the time of manufacturing may reduce costs and enable compact storage of the devices, and the easy deployment may reduce installation time. Connecting power devices at the time of manufacturing may include directly connecting conductors (e.g. by soldering or screwing the conductors into place within a power device enclosure) between adjacent power devices. Furthermore, preconnecting power devices with cables permanently connected may reduce the number of connectors (e.g. MC4^{™} connectors) featured in each power device from four connectors to two connectors (retaining the two connectors for connecting to a PV generator at the power device input terminal but removing the two connectors for connecting between power devices at the power device output). As connectors may be costly components, substantial savings may be realized. Additionally, preconnecting power devices during manufacturing may increase system safety. For example, if improperly connected, connection points between power devices may be susceptible to overheating, arcing and/or other unsafe event which may result in fire. Preconnecting power devices during manufacturing without use of connectors may increase system safety by reducing the number of connection points from four per power device to two per power device.

Certain variations of power-circuit chains may be wound around a storage spool similar to spools used for storing electrical cables, and deployed in photovoltaic installations by unrolling the spool and coupling the power devices to photovoltaic generators as the power devices are unwound from the spool.

In some variations of power-circuit chains, a distance between adjacent power devices may correspond to an estimated distance between photovoltaic generator junction boxes in a photovoltaic installation, to enable adjacent power devices in the power-circuit chain to be coupled to adjacent photovoltaic generators. In some variations, more than one photovoltaic generator may be coupled to each power device. For example, in some solar installations, two PV generators may be coupled in series and the two generators may then be coupled to one power device, in which case the length between adjacent power devices may be about double the distance between adjacent generators.

The photovoltaic power devices may include, but are not limited to, DC/DC converters, DC/AC inverters, devices configured to measure and monitor photovoltaic parameters, communication devices, safety devices (e.g., fuses, circuit breakers and Residual Current Detectors) and/or Maximum Power Point Tracking (MPPT) devices. The power generation units may include, but are not limited to, photovoltaic modules (e.g. photovoltaic cells, photovoltaic panels), batteries, wind turbines, hydroelectric turbines and fuel cells.

As noted above, this Summary is merely a summary of some of the features described herein and is provided to introduce a selection of concepts in a simplified form that are further described below in the Detailed Description. The Summary is not exhaustive, is not intended to identify key features or essential features of the claimed subject matter and is not to be a limitation on the claims.

### BRIEF DESCRIPTION OF THE DRAWINGS

These and other features, aspects, and advantages of the present disclosure will become better understood with regard to the following description, claims, and drawings. The present disclosure is illustrated by way of example, and not limited by, the accompanying figures. A more complete understanding of the present disclosure and the advantages thereof may be acquired by referring to the following description in consideration of the accompanying drawings, in which like reference numbers indicate like features, and wherein:
Figs. 1A-1E are part schematic, part block diagrams of different power devices configured for different photovoltaic systems.
Figs. 2A-2C depict photovoltaic power devices with different connector configurations.
Fig. 3 is part schematic, part block diagram depicting a photovoltaic power device.
Figs. 4A and 4B depict strings of photovoltaic power devices coupled by conductors.
Fig. 4C depicts a variation of a photovoltaic power device.
Figs. 5A-5C depict portions of photovoltaic strings, with a plurality of photovoltaic power devices coupled to each other by conductors and coupled to photovoltaic generators.
Fig. 6 depicts a string of photovoltaic power devices coupled by conductors, stored on a storage device.
Fig. 7A depicts a string of power devices coupled by conductors.
Fig. 7B depicts internal features of a power device from a string of power devices coupled by conductors.
Fig. 7C depicts intermittent terminal connectors along a string of photovoltaic power devices coupled by conductors.
Figs. 8A-8C depict flowcharts of methods for manufacturing and using a string of power devices.

### DETAILED DESCRIPTION

In the following description reference is made to the accompanying drawings, which form a part hereof.

Since power devices may often be used in bulk (e.g., one power device per photovoltaic generator may be used in a solar installation including multiple photovoltaic strings, each string including ten, twenty or more photovoltaic generators), costs may be reduced and deployment may be easier by packaging power devices in a form which enables multiple devices to be strung out and deployed at one time, along a photovoltaic string. Furthermore, use of a storage device such as a spool to wind multiple cable-connected devices around can make storage and deployment easier and cheaper.

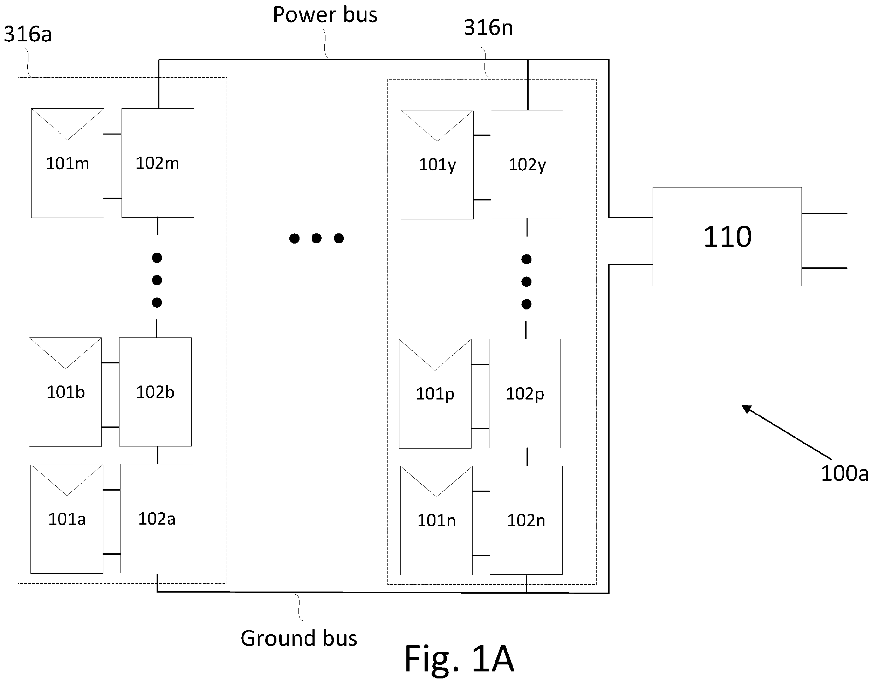

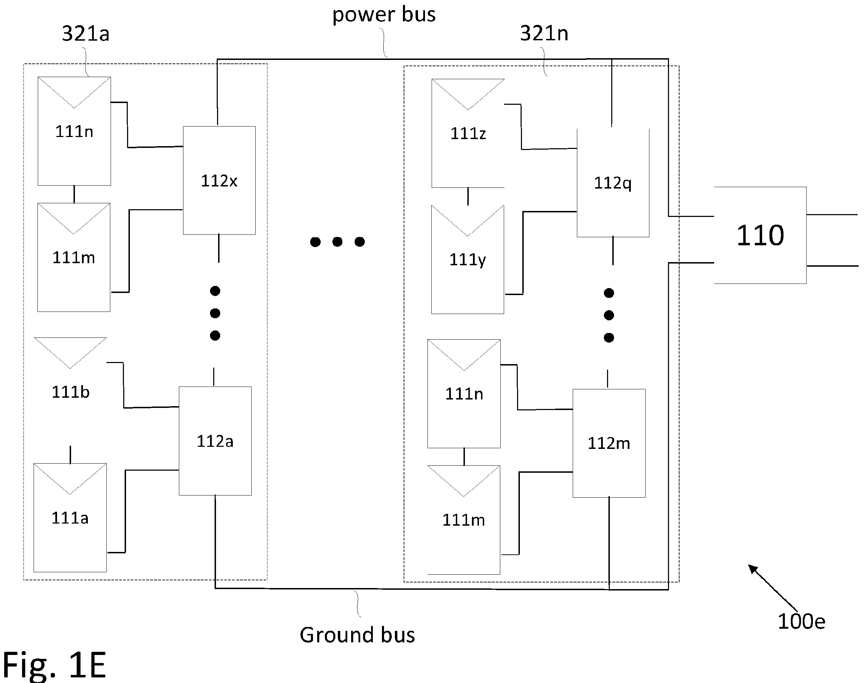

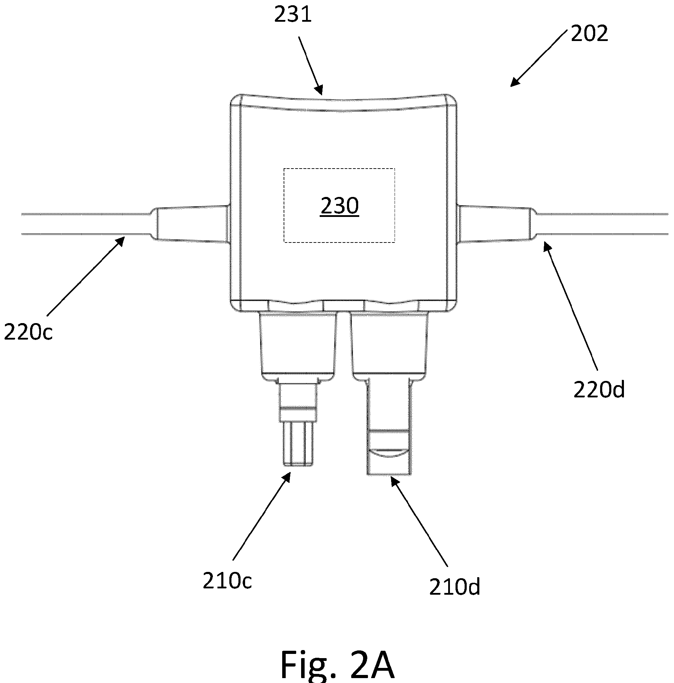

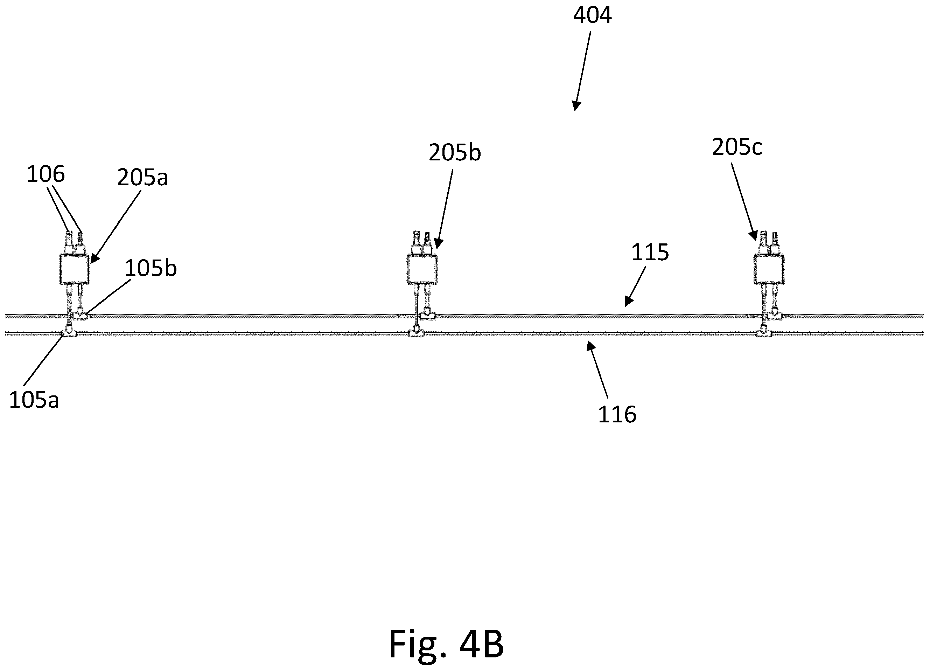

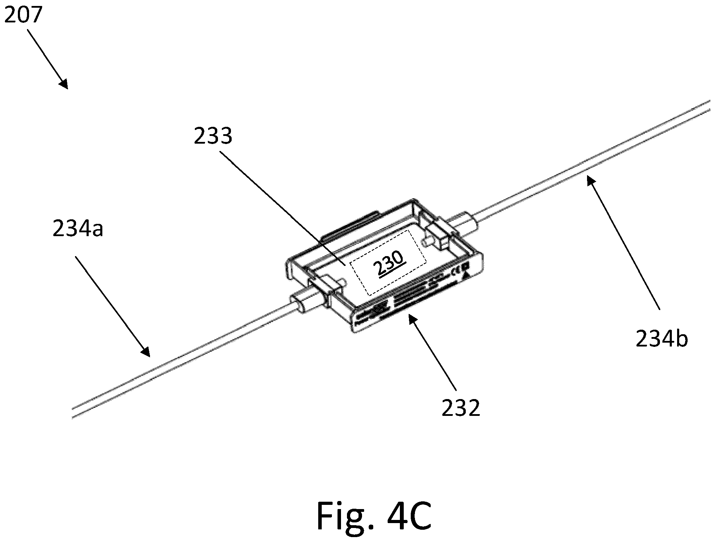

The following non-limiting examples figures illustrate two types of aspects that may be used together: aspects of systems with different electrical configurations (for example, as in Figs. 1A thru IE), and aspects of power devices with different connector configurations (for example, as in Figs. 2A thru 2C, 4B, and 4C). These two types of aspects (system electrical and device connectors) are determined by the power generation system electrical design (also referred to as installation design) and the placement choice of the power devices relative to the panels. For example, each specific installation may have an electrical design, which in turn may determine a power device electrical configuration to match. This may ensure that all power devices will behave electrically in the same string or installation as determined by the electrical configuration of the system. The power device electrical configuration may include specifications of input and output voltage/current ranges, operational parameters (such as timings and control loops), or the like.

Referring to Fig. 1A, illustrative photovoltaic installation 100a may include a plurality of photovoltaic (PV) modules 101a-y. Photovoltaic generators may also be referred to as "photovoltaic modules". Each PV generator 101a-y may be coupled to a photovoltaic power device 102a-y and electrically configured for installation 100a. The devices 101a-y may collectively, individually and interchangeably be referred to herein as devices 101, and the devices 102a-y may collectively, individually and interchangeably be referred to herein as devices 102. Devices 102 may be electrically configured to match the configuration of installation 100a. Although each device 102 may be configured for a similar system electrical configuration, the other aspects of the devices may be different, such as different mechanical configurations, different connector configurations, different physical configurations, different software configurations, and other different aspects.

In some variations, one or more PV power device 102a-y (and all other power devices described herein) may comprise a power conversion circuit such as a direct current - direct current (DC/DC) converter such as a buck, boost, buck-boost, flyback and/or forward converter. In some variations, one or more PV power device 102a-y may comprise a direct current - alternating current (DC/AC) converter, also known as an inverter or a microinverter. In some variations, one or more PV power device 102a-y may include a Maximum Power Point Tracking (MPPT) and/or Impedance Matching circuit with a controller, configured to extract regulated (e.g. increased) power from the PV generator the power device is coupled to. One or more PV power device 102a-y may further comprise a control device such as a microprocessor, Digital Signal Processor (DSP) and/or a field-programmable gate array (FPGA). In some variations, one or more PV power device 102a-y may comprise circuitry and/or sensors configured to measure parameters on or near the photovoltaic generator, such as the voltage and/or current output by the generator, the power output by the generator, the irradiance received by the generator and/or the temperature on or near the generator.

As depicted in Fig. 1A, a plurality of PV power devices 102a-m are coupled in series to form a first photovoltaic string 316a, and a second plurality of PV power devices 102n-y are coupled in series to form a second photovoltaic string 316b. One terminal of each photovoltaic string (e.g., 316a-316n) may be coupled to a power bus, and the other terminal of each photovoltaic string (e.g., 316a-316n) may be coupled to a ground bus. As used herein, a "ground" bus refers to a return bus that may be isolated from other ground buses, connected to other ground buses, or connected to earth ground. In some variations, the power and ground buses may be input to system power device 110. System power device 110 may comprise a DC/AC converter, and the DC/AC converter may output AC power to the grid, home or other loads and/or power distribution systems.

While PV generators and PV power devices in each photovoltaic string, are identified with a limited range of reference designators (e.g., 101a-101m, 101n-101y, 102a-102m, and 102n-y), each photovoltaic string (in all variations disclosed herein) may include any number of PV power devices and/or PV generators. Similarly, while the photovoltaic strings are identified with a limited range of reference designators (e.g., 316a-316n) each system 100a (and in all systems disclosed herein) may include any number of photovoltaic strings.

In some variations, the photovoltaic power devices may comprise microinverters, and an additional inverter (e.g. part of system power device 110 connected between the power devices and the load or power distribution system) may not be included. In some variations, the power devices may output a time-varying DC signal which emulates a rectified sine wave, in which case system power device 110 may comprise a full-bridge circuit configured to convert the rectified sine wave to a standard, alternating sine wave. In some variations, system power device 110 may include a combiner box for combining power from a plurality of photovoltaic strings (e.g. 316a-316n). In some variations, system power device 110 may comprise sensors/sensor interfaces for measuring or receiving measurements of one or more parameters (e.g. current, voltage, power, temperature etc.) associated with PV strings 316a-316n. In some variations, system power device 110 may include one or more safety switches for disconnecting and/or short circuiting PV strings 316a-316n (e.g., in case of a potentially unsafe condition or in response to a manual trigger such as a rapid-shutdown switch or button being activated).

Since PV power devices of known systems may be generally manufactured, packaged and sold separately, PV installations which include a plurality of PV generators, e.g., installation 100a, may require unpacking a large number of devices, individually coupling each device to its corresponding photovoltaic generator, and then coupling the power devices to one another using cables which may be sold separately as well. In some variations introduced herein, a power device chain is provided. The power device chain may include a plurality of power devices each coupled to at least one other power device using conductors of appropriate length at the time of manufacturing. Accordingly, power device chains as described herein may be packaged and sold as a single unit, and deployed as a single unit when installing installation 100a. For example, power devices 102a-m may comprise a string of power devices or part of a string of power devices, and may be coupled to one another during manufacturing. During installation, the string may simply be strung out alongside photovoltaic modules 101a-m and each device may be coupled to its corresponding module quickly and easily, forming photovoltaic string 316a.

As shown in Fig. 1A, installation 100a may include a plurality of photovoltaic strings 316a-n, with a terminal of each photovoltaic string 316a-n being coupled to the power bus and the other terminal being coupled to the ground bus.

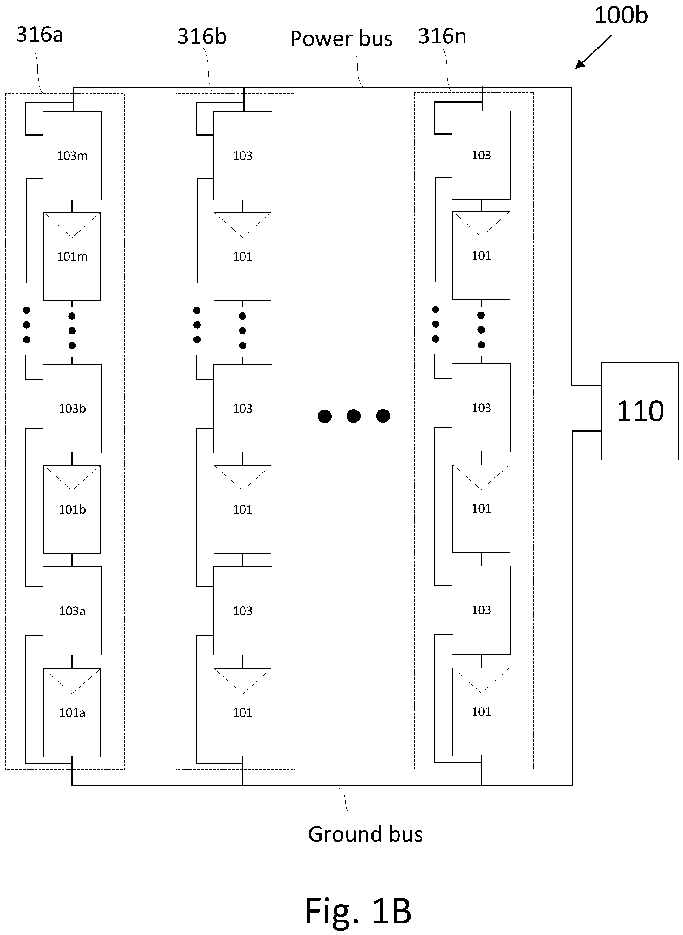

Referring now to Fig. 1B, illustrative system 100b may share many of the same characteristics as illustrative installation 100a of Fig. 1A, but the wiring of photovoltaic strings may differ in some respects. For example, in illustrative system 100b, each photovoltaic power device 103a-m may be coupled to two photovoltaic generators and electrically configured for installation 100b. For example, photovoltaic power device 103a may be coupled to generators 101a and 101b, power device 103b may be coupled to generators 101b and 101c (not shown), and so on. Wiring each photovoltaic string (e.g. 316a) in this manner may save money by requiring thinner and fewer cables to couple the power devices to the generators and to one another. The devices 103a-m may collectively, individually and interchangeably be referred to herein as devices 103, and similarly, other electrical configurations of power devices may be referred to collectively be using the reference number and omitting the reference letter associated with individual instances of a similar device.

As shown in Fig. 1B, the power devices may be pre-coupled to one another during manufacturing, packaged and/or sold together, and deployed easily, similar to as described with reference to installation 100a shown in Fig. 1A. For effective system operation and for easy and fast coupling of the power devices to the photovoltaic generator(s) the power devices may be arranged to be coupled to PV panels, and the electrical and/or mechanical design of the power devices used for systems such as 100a (such as 102) may differ from the design used for such as systems 100b (such as 103). The pre-coupling, packaging and easy deployment described herein may be applied to different kinds of power devices used in different kinds of photovoltaic systems, regardless of mechanical design and electrical topology details which may be specific to certain power devices.

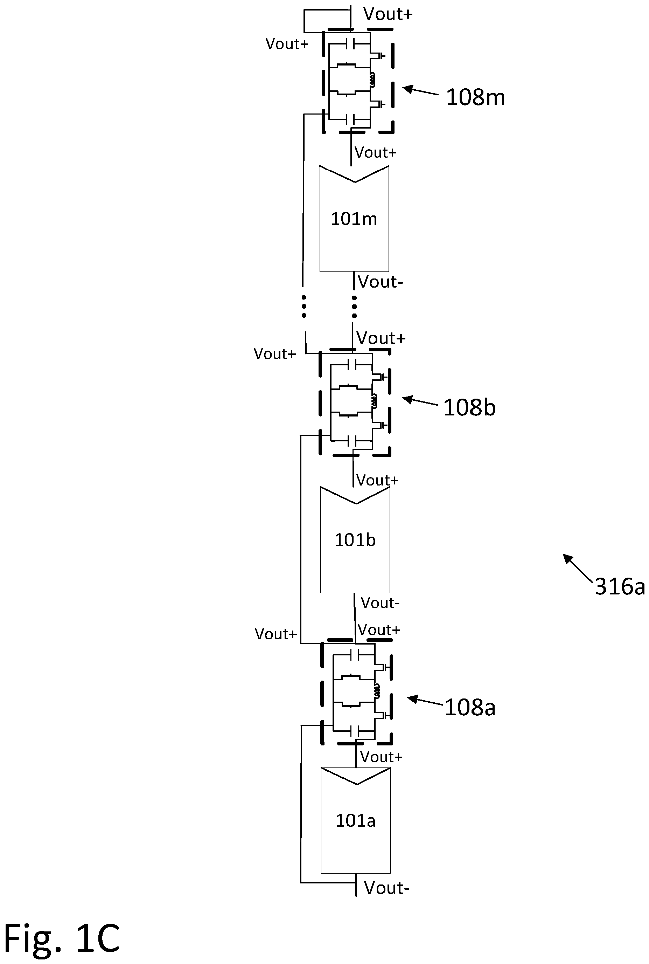

Reference is now made to Fig. 1C, which shows a photovoltaic string (e.g., 316a) in which each photovoltaic power device is coupled to two photovoltaic modules. In this variation, PV power devices 108a-m (which may be an example of PV power device 103 in Fig. 1C) comprise Buck-Boost DC/DC converters. Additional circuitry (e.g., a controller, voltage and current sensors, control logic, etc.) may be included in power devices 108a-m, but is not explicitly depicted in Fig. 1C. Additional circuitry and/or wiring configurations may be used to couple power devices to photovoltaic generators according to various aspects of the present disclosure.

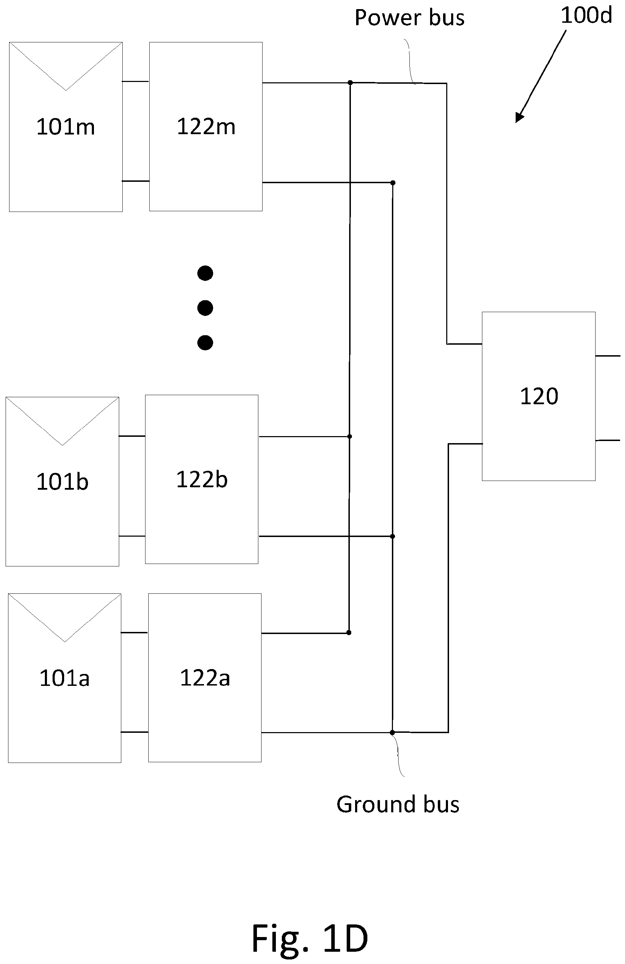

Referring to Fig. 1D, illustrative variations may include photovoltaic installation 100d, comprising a plurality of photovoltaic generators 101a-m each coupled to a power device 122a-m. Power device 122a-m may be electrically configured for installation 100d. Each power device 122a-m may have two outputs, one coupled to a mutual power bus, and one coupled to a mutual ground bus, coupling all the power devices in parallel. In some variations, one or more of the power devices 122a-m may comprise a DC/DC converter, with each converter's positive output coupled to the power bus, and the negative terminal coupled to the ground bus. In some variations, one or more of the power devices 122a-m may comprise a DC/AC converter, with the AC outputs synchronized to allow parallel coupling. In some variations including an AC output by the power devices, the AC output may be a single phase coupled to the power and ground buses, and in some variations three or more phases may be output to more than two buses. The system may further include the power bus and ground bus being input to grid-coupling device 120. In variations including a DC output by the power devices, grid coupling device 120 may include a DC/AC inverter. In variations including an AC output by the power devices, grid coupling device 120 may include a transformer. Grid coupling device 120 may be similar to or the same as system power device 110 of Fig. 1A, and may comprise safety devices (e.g. sensors, circuit breakers, fuses, etc.) and/or control and/or monitoring devices.

Referring to Fig. IE, more than one photovoltaic module may be coupled to each photovoltaic power device. System 100e includes two photovoltaic modules (e.g. photovoltaic panels or a different type of photovoltaic generator) 111a, 111b coupled to each other in series, with the series coupled modules 111a and 111b coupled across an input terminal of a photovoltaic power device 112a. Photovoltaic power device 112a may be electrically configured for installation 100e. Similar to other variations disclosed herein, outputs of a plurality of power devices 112a-x may be coupled in series to form a photovoltaic string 321a, with multiple strings 321a-n coupled in parallel between the ground and power buses. In some variations, inverter 110 may receive a DC input from the ground and power buses and output AC power to the grid or home. In similar variations, the power devices may be precoupled to one another at the time of manufacturing, with the conductors coupling the power devices being sized (in length and/or gauge) to allow the desired number of photovoltaic generators to be coupled to each power device. For example, if each two PV generators are to be coupled to one another and to a single power device, the length of each conductor between power devices being around double the width or length of each photovoltaic module.

Devices 102, 103, 108, 122, and 112 represent power devices with different electrical specifications (such as input and output voltage and current limits, timings, control loops, impedances, or the like) configured for respective different installation electrical configurations 100a, 100b, 100d, and 100e.

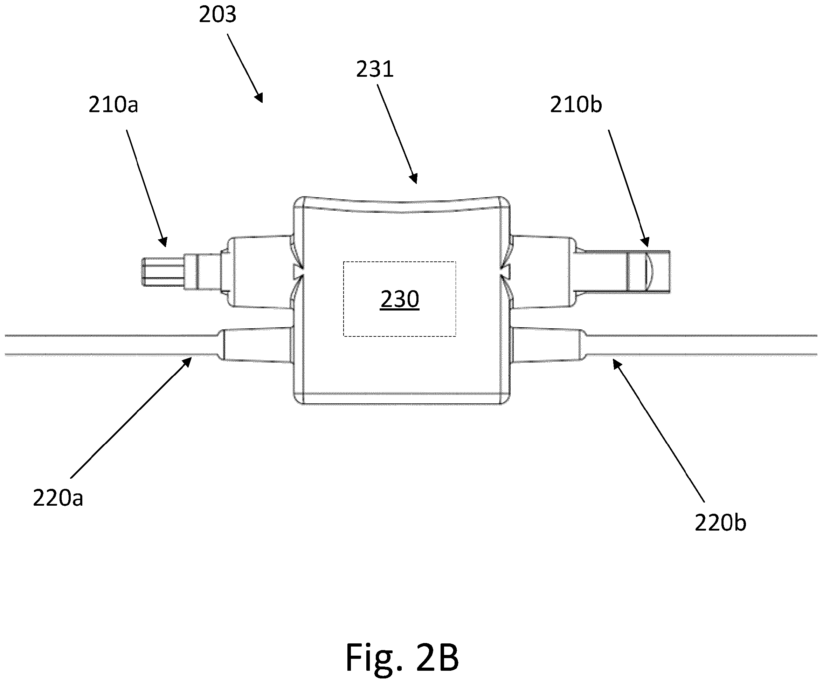

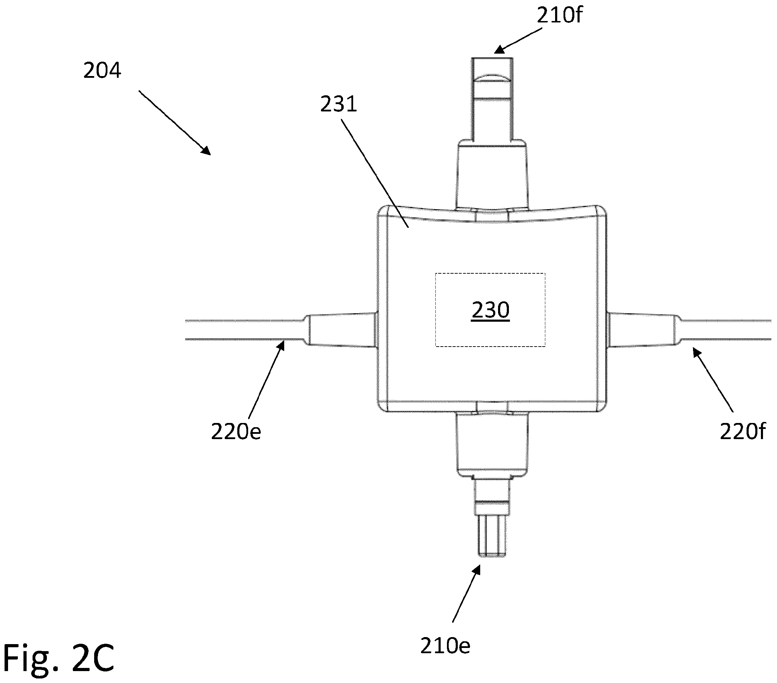

Following Figs. 2A, 2B, and 2C as well as Figs 4B and 4C illustrate different mechanical configurations of input and output terminals as at 202, 203, 204, 205, and 207. These electrical and mechanical configurations may be selected in any combination. Following examples may illustrate several of these combinations, but these should not be seen as limiting examples.

Referring to Fig. 2A, photovoltaic power device 202may be configured in various ways. In one illustrative variation, photovoltaic power device 202 may comprise a casing 231 containing circuitry 230, input terminals 210c and 210d, and output conductors 220c and 220d. In other variations, casing 231 may be replaced by a surface on which circuitry 230 is mounted, the surface being snapped to a different part of a photovoltaic apparatus such as a junction box. In some variations, there may be more than two input terminals. For example, some variations may include four input terminals for coupling the power device to two photovoltaic modules, the power device processing power input from both modules. Photovoltaic device 202 may be electrically configured for installations 100a, 100b, 100d, or 100e (e.g., as device 102, 103, 108, 112, or 122).

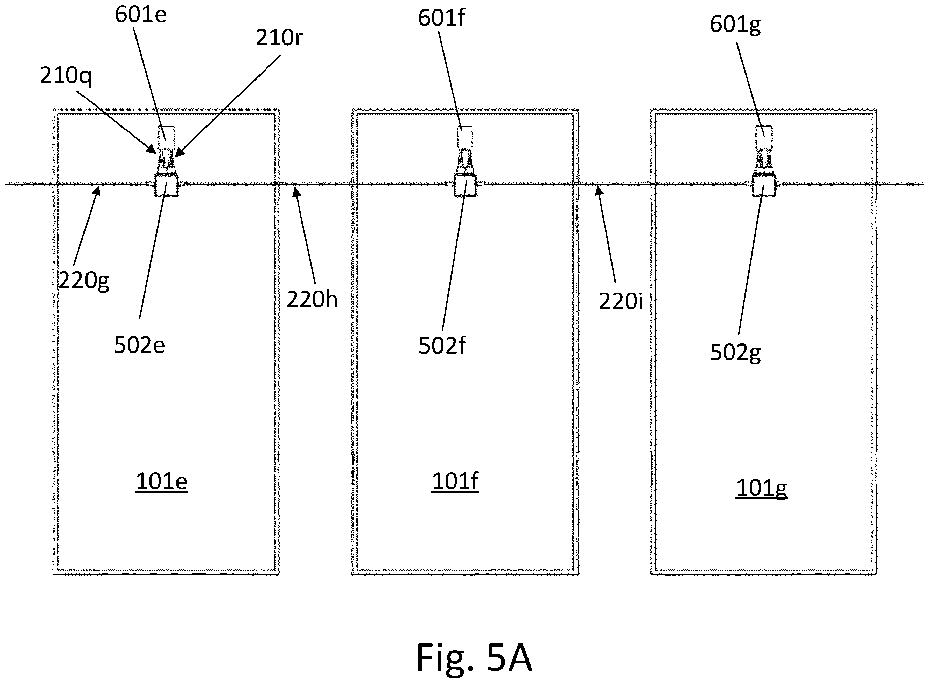

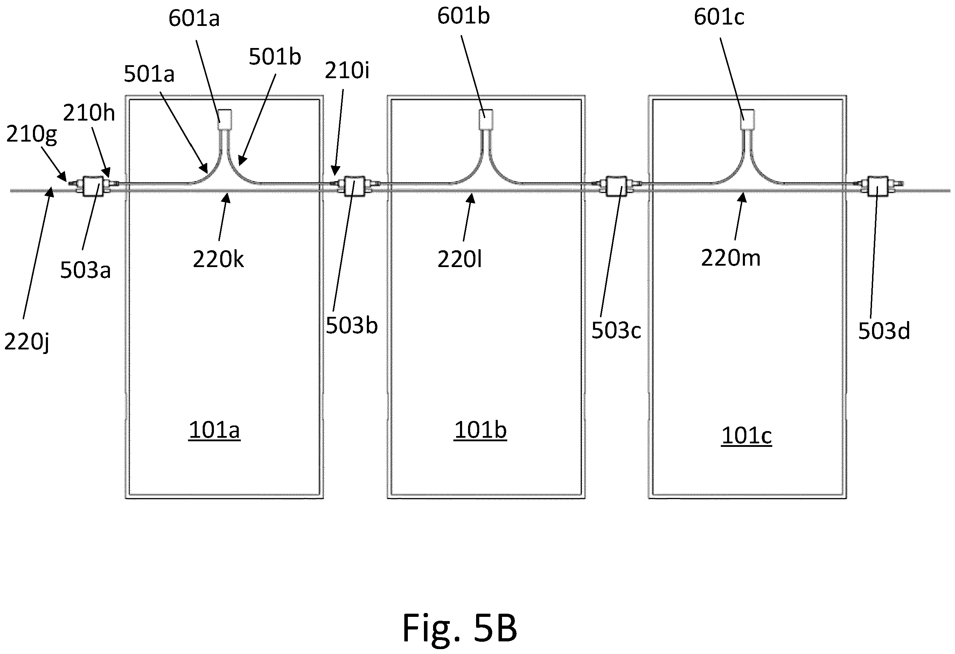

In some variations, circuitry 230 may include a power conversion circuit such as a direct current - direct current (DC/DC) converter such as a buck, boost, buck-boost, Cuk, charge pump, flyback and/or forward converter. In some variations, circuitry 230 may include a direct current - alternating current (DC/AC) converter, also known as an inverter or a microinverter. In some variations, circuitry 230 may include a Maximum Power Point Tracking (MPPT) circuit with a controller configured to extract increased power from the PV generator the power device is coupled to. Circuitry 230 may further comprise a control device such as a microprocessor, Digital Signal Processor (DSP), Application Specific Integrated Circuit (ASIC) and/or a Field Programmable Gate Array (FPGA). In some variations, circuitry 230 may include circuitry and/or sensors configured to measure parameters on or near the photovoltaic generator, such as the voltage and/or current output by the generator, the power output by the generator, the irradiance received by the generator and/or the temperature on or near the generator and/or power device. Input terminals 210c and 210d may be coupled to outputs of one or more photovoltaic modules, and may also be coupled to circuitry 230 for processing and/or measuring the power output by the corresponding one or more photovoltaic modules. Output conductors 220c and/or 220d may couple the photovoltaic power device to adjacent devices, to form a serial or parallel photovoltaic string. The input terminals and output conductors may be physically connected to different parts of casing 231. For example, the input terminals 210c and 210d may be physically located next to one another along one side of casing 231, with output conductors 220c and 220d occupying opposite sides of casing 231, on either side of input terminals 210c and 210d. In other variations, the input terminals and output conductors may be configured differently, as will be shown herein Figs. 2B, 2C, 4B, and 4C. The location of the input terminals and output conductors may be chosen considering the layout and wiring design of the system at hand, as well as the installation electrical configuration such as for installations 100a-e. Mechanical considerations, such as enabling optimal storing of the entire chain of power devices, may also factor into designing the location of the input terminals and output conductors. The photovoltaic power device 202 shown in Fig. 2A may be particularly suited for coupling to a single photovoltaic generator (in systems such as those shown in Figs. 1A, 1D, and 5A), since the input terminals are next to each other, though photovoltaic power device 202 may also be deployed in a way that couples it to two generators (such as 103 shown in Fig. 1B, 108 shown in Fig. 1C, 112 of Fig. 1D, or 503 of Fig. 5B).

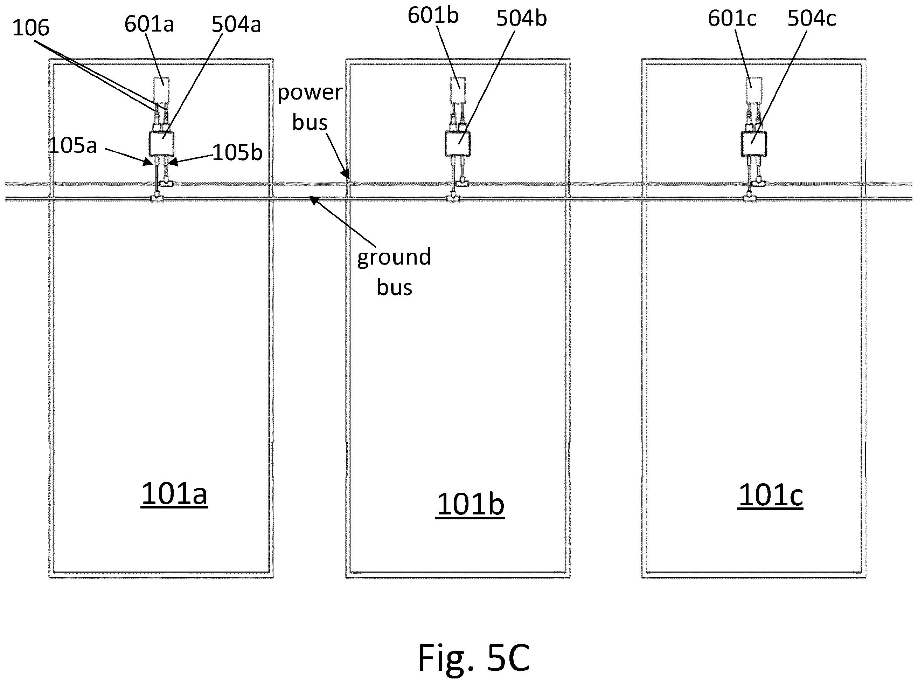

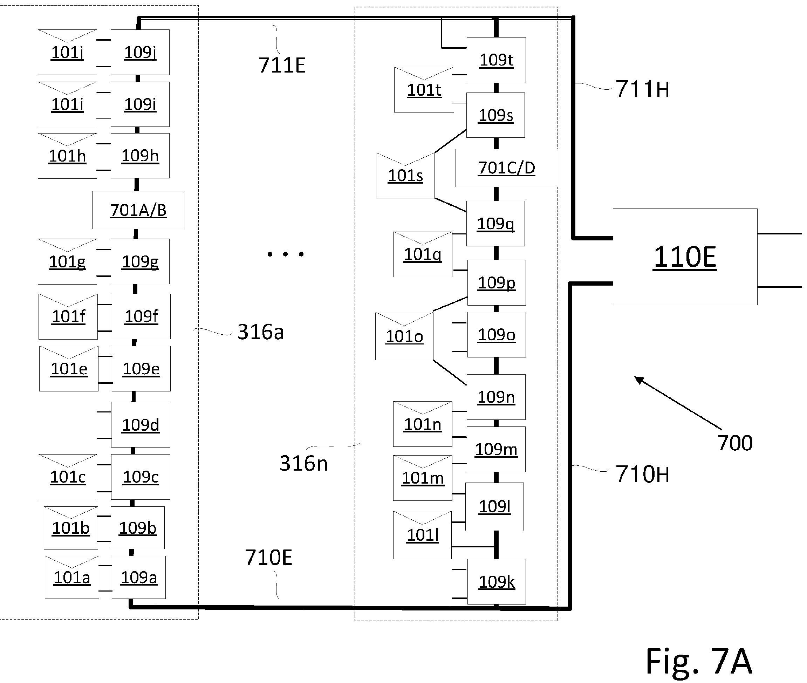

Referring now to Fig. 2B, the input terminals and output conductors may be configured such that input terminal 210a is adjacent to output conductor 220a, both connected to a side of casing 231, and on the opposite side of casing 231 input terminal 210b is adjacent to output conductor 220b. This illustrative variation may be suited for coupling photovoltaic power device 203 to two photovoltaic generators (such as 103 of shown in Fig. 1B, 108 shown in Fig. 1C,112 of Fig. 1D, 503 of Fig. 5B, or 109 of Fig. 7A), since the two input terminals may be coupled to two generators on either side of the power device. Photovoltaic power device 203 may also be deployed in a way that couples it to a single generator (such as 102 of Fig. 1A, 122 of Fig. 1D, 502 of Fig. 5A, 504 of Fig. 5C, or 109a-j of Fig. 7A). Photovoltaic device 203 may be configured for installations 100a, 100b, 100d, or 100e.

Referring now to Fig. 2C, the input terminals and output conductors may be configured such that input terminals 210e and 210f are located on opposing sides of casing 231, while output conductors 220e and 220f are located on the other pair of opposite sides of casing of photovoltaic power device 204. Thus, four sides of the casing contain either an input terminal or an output conductor. This illustrative variation may, in some configurations, enable optimal packaging of the chain of power devices and enable it to be stored in a compact convenient way. The chain according this variation can be deployed in a way that couples each power device to either one (for example, such as 102 of Fig. 1A, 122 of Fig. 1D, 502 of Fig. 5A, 504 of Fig. 5C, or 109a-j of Fig. 7A) or two (for example, such as 103 of shown in Fig. 1B, 108 shown in Fig. 1C, 112 of Fig. IE, 503 of Fig. 5B, or 109 of Fig. 7A) photovoltaic modules. Photovoltaic device 204 may be configured for installations 100a, 100b, 100d, or 100e.

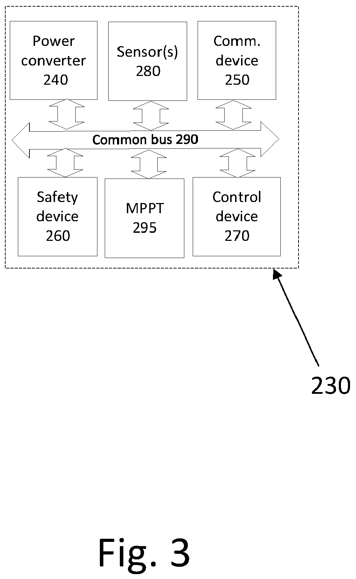

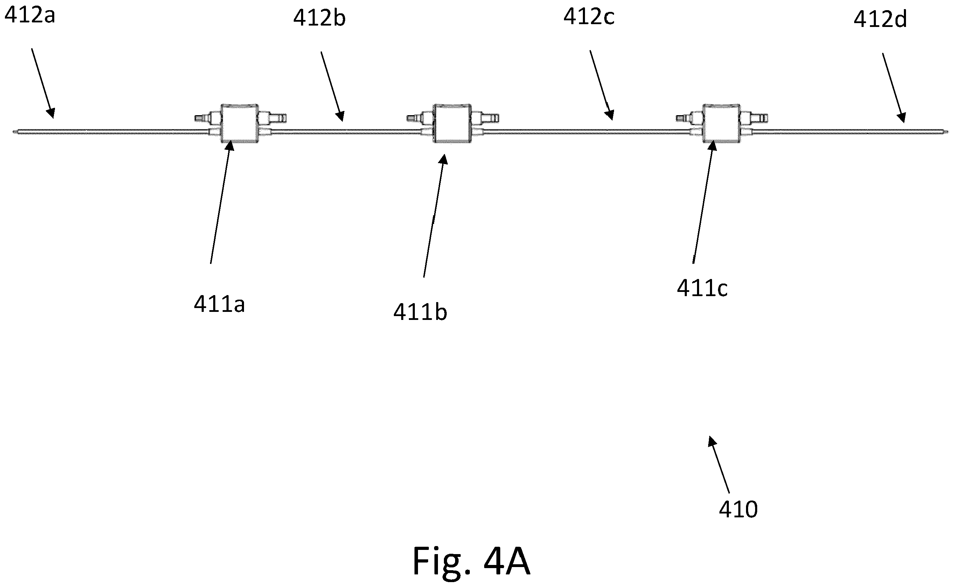

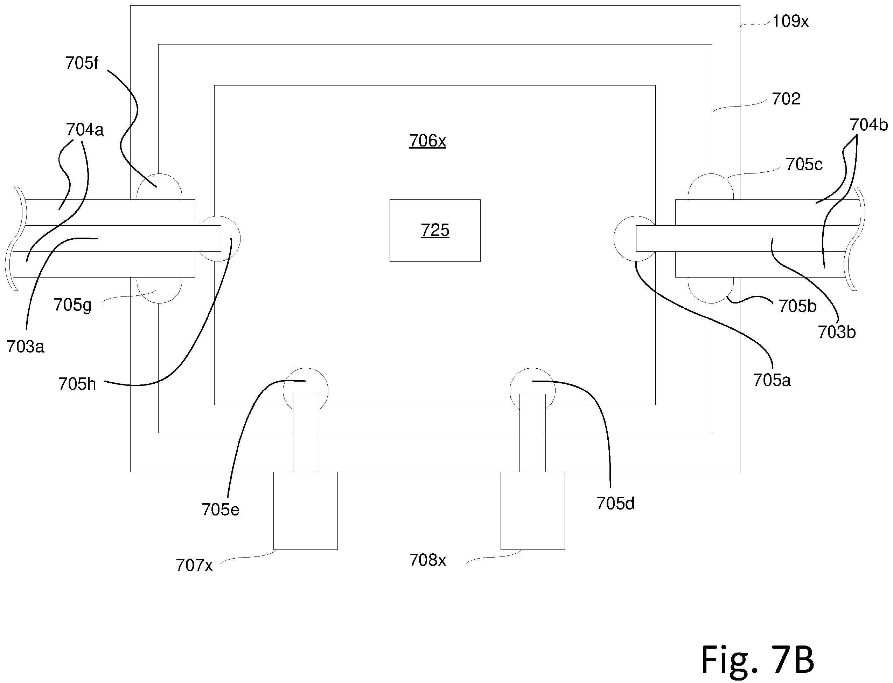

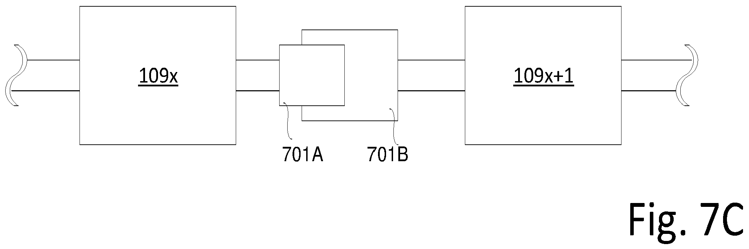

Referring now to Fig. 3, photovoltaic power devices may house circuitry 230. Any of the photovoltaic power devices referred to herein, may include circuitry 230, including for example, 102 of Fig. 1A, 103 of Fig. 1B, 108 of Fig. 1C, 122 of Fig. 1D, 112 of Fig. IE, 202 of Fig. 2A, 203 of Fig. 2B, 204 of Fig. 2C, 411 of Fig. 4A, 205 of Fig. 4B, 207 of Fig. 4C, 502 of Fig. 5A, 503 of Fig. 5B, 504 of Fig. 5C, and 109 of Figs. 7A, 7B, and 7C. In some variations, circuitry 230 may include power converter 240. Power converter 240 may include a direct current-direct current (DC/DC) converter such as a buck, boost, buck-boost, flyback and/or forward converter. In some variations, power converter 240 may include a direct current - alternating current (DC/AC) converter, also known as an inverter or a microinverter.

In some variations, circuitry 230 may include Maximum Power Point Tracking (MPPT) circuit 295, configured to extract increased power from the PV generator the power device is coupled to. In some variations, power converter 240 may include MPPT functionality, and MPPT circuit 295 may not be included. Circuitry 230 may further comprise control device 270 such as a microprocessor, Digital Signal Processor (DSP), ASIC and/or an FPGA. Control device 270 may control and/or communicate with other elements of circuitry 230 over common bus 290.

In some variations, circuitry 230 may include circuitry and/or sensors 280 configured to measure parameters on or near the photovoltaic generator, such as the voltage and/or current output by the generator, the power output by the generator, the irradiance received by the generator and/or the temperature on or near the generator. In some variations, circuitry 230 may include communication device 250, configured to transmit and/or receive data and/or commands from other devices. Communication device 250 may communicate using Power Line Communication (PLC) technology, or wireless technologies such as ZigBee^{®}, Wi-Fi^{™}, cellular communication or other wireless methods. In some variations, PLC signals may be transmitted and/or received over output conductors (such as 220a, 220b, 220c, 220d, 220e and/or 220f of Figs. 2A, 2B, and 2C, herein collectively, individually and interchangeably referred to as output conductors 220). In some variations, a communications link (e.g. an optical fiber) may be integrated with output conductors 220and may be communicatively coupled to communication device 250.

In some variations, a thermal sensor device (e.g. a thermocouple device or a Linear Heat Detector) may be integrated with output conductors 220 and may provide temperature measurements (e.g. measurements obtained at various locations along output conductors 220) to control device 270. Input terminals (such as 210a, 210b, 210c, 210d, 210e, and/or 210f of Figs. 2A, 2B, and 2C, collectively, individually and interchangeably referred to as input terminals 210) may be coupled to outputs of one or more photovoltaic modules, and may also be coupled to circuitry 230 for processing and/or measuring the power output by the corresponding photovoltaic module. In some variations, circuitry 230 may include safety devices 260 (e.g. fuses, circuit breakers and Residual Current Detectors). The various components of circuitry 230 may communicate and/or share data over common bus 290.

Fig. 4A depicts chain 410. Chain 410 may comprise plurality of photovoltaic power devices 411a-c coupled by plurality of conductors 412a-d. In some variations, a chain of photovoltaic power devices similar to chain 410 may comprise ten, twenty or even a hundred photovoltaic power devices. In some variations, chain 410 may be manufactured and/or sold as a single unit. Photovoltaic power devices 411a-c may be similar to or the same as photovoltaic power devices described herein, for example, photovoltaic power device 102 of Fig. 1A (connected to one PV panel), or photovoltaic power device 103 of Fig. 1B (connected to two PV panels). Conductors 412a-d may be directly coupled (e.g. connected) to the output terminals of a DC/DC converter or DC/AC inverter included in a photovoltaic power device (e.g. 411a-c). The length of each output conductor 412a-d may be appropriate to enable each PV power device to be coupled to photovoltaic generators in a photovoltaic string. Since different PV generators may have different dimensions, and since the PV generators may be oriented differently during deployment, the distance between power devices (i.e., the length of each output conductor) may vary in different chains. However, many PV generators (e.g. PV panels) are of similar dimensions, and PV panels are generally oriented in one of two ways (vertically, aka "portrait", or horizontally, aka "landscape"), so a chain of photovoltaic power devices (e.g. chain 410) featuring a standard distance between power devices may be deployed many photovoltaic systems. For example, photovoltaic panels are generally manufactured in standard sizes, such as around 65 by around 39 inches for residential installations or around 77 by around 39 inches for commercial installations. Therefore, chains of power devices configured to be deployed with panels of dimensions similar to those cited above may include conductors which are sized in proportion to the panel dimensions, for example, around 39, around 65 or around 77 inches long. While the input terminals and output conductors 412a-d of illustrative power devices 411a-c denoted in Fig. 4A are located similarly to what is shown in Fig. 2B, variations may have input terminals and output conductors located similarly to what is shown in Fig. 2A, or various other configurations without departing from the scope of the present disclosure.

Conductors 412a-412d may be (e.g. during manufacturing or chain 410) internally connected to circuitry (e.g. circuitry 230 of Fig. 3) inside photovoltaic power devices 411a-411c at the time of manufacturing. For example, conductor 412b may be at a first end, for example, soldered, crimped, or connected via a screw to a power converter or monitoring device in photovoltaic power device 411a, and may be at a second end, for example, soldered, crimped, or connected via a screw, to a power converter or monitoring device in photovoltaic power device 411b. Preconnecting conductors between power devices may reduce the number of connectors (e.g. MC4^{™} connectors) featured in each power device from four (two connectors for connecting to a PV generator at the power device input and two connectors for connecting between power devices at the power device output). As connectors may be costly components, substantial savings may be realized. Additionally, preconnecting power devices during manufacturing may increase system safety. For example, if improperly connected, connection points between power devices may be susceptible to overheating, arcing and/or other unsafe event which may result in fire. Preconnecting conductors between power devices during manufacturing without use of connectors may increase system safety by reducing the number of connection points from four per power device to two per power device.

Referring now to Fig. 4B, a chain of photovoltaic power devices 404 may comprise output conductors which double as ground and power buses of a parallel-connected photovoltaic installation similar to the system shown in Fig. 1D. Input terminals 106 may be coupled to the outputs of a photovoltaic system. Output conductor 105a may be coupled to the power bus using a T-connector, and output conductor 105b may be coupled to the ground bus using a T-connector. The input terminals 106 and output conductors 105a, 105b are denoted explicitly in FIG. 4B only for power device 205a, but are similarly included on each power device 205 (such as, 205b, 205c). One or more power device 205a-c may comprise a DC/DC converter or DC/AC inverter configured to output a DC or AC voltage common to all parallel-connected devices. In some variations, one or more power device 205a-c may comprise a Maximum Power Point Tracking (MPPT) circuit with a controller, configured to extract maximum power from the PV generator the power device is coupled to. One or more power device 205a-c may further comprise a control device such as a microprocessor, Digital Signal Processor (DSP), ASIC and/or an FPGA. In some variations, one or more power device 205a-c may comprise circuitry and/or sensors configured to measure parameters on or near the photovoltaic generator, such as the voltage and/or current output by the generator power output by the generator, the irradiance received by the generator and/or the temperature on or near the generator and/or power device. The power device chain 404 in the variation shown in Fig. 4B may include two long conductors, ground bus 116 and power bus 115, with PV power devices coupled to the two conductors, with the distance between adjacent power devices enabling them to be coupled to adjacent PV generators in a photovoltaic installation. The power devices may be coupled to the conductors at the time of manufacturing, and may be compactly stored along with the conductors, enabling fast and easy deployment.

Referring now to Fig. 4C, illustrative variations of photovoltaic power device 207 may feature an open casing or lid 232 instead of a closed casing such as casing 231 depicted in Fig. 2A. Lid 232 may include circuit-mounting surface 233 which may be used to mount circuitry 230. Circuitry 230 may comprise any and/or all of the components described herein with reference to other figures. For example, circuitry 230 may comprise a power converter such as a DC/DC or a DC/AC converter. As another example, circuitry 230 may comprise a monitoring device in addition to or instead of a power converter. In some variations, power device 207 may be designed to be connectable to a portion of a photovoltaic panel junction box, enabling circuitry 230 to be coupled directly to the electronics located in the panel's junction box.

In some variations, direct coupling of the lid to a photovoltaic generator junction box may render external input terminals unnecessary, for example input conductors are connected directly to the PV panel conductors behind the junction box, or to conductors within the junction box, and the device 207 is attached to the panel as an open cover or the junction box as a lid respectively. Output conductors 234a-b may be located on opposite sides of lid 232, and may be coupled to additional power devices (not depicted explicitly in the figure), forming a chain of serially connected devices. Similar to other illustrative variations, the distance (i.e. the length of the coupling conductor) between adjacent power devices 207 may be of appropriate length enabling coupling of adjacent power devices to adjacent photovoltaic modules in a photovoltaic installation. The power devices may be coupled to the conductors at the time of manufacturing, and may be compactly stored along with the conductors, enabling fast and easy deployment.

Reference is now made to Fig. 5A, which depicts a portion of a chain of power devices coupled to photovoltaic generators in a variation of the system. PV generator 101e may include junction box 601e, featuring two outputs which may be coupled to input terminals 210q and 210r of power device 502e. Power generated by the PV generator may be transferred via the junction box to the power device via the input terminals 210q and 210r, which may be coupled directly to the j unction box. Power device 502e may further include circuitry 230 (not explicitly depicted in the figure) which may comprise various elements as described herein. Output conductor 220g may couple power device 502e to an adjacent power device on one side (not shown explicitly), while output conductor 220h may couple power device 502e to an adjacent power device 502f on the other side, with output conductor 220i coupling power device 502f to power device 502g. The input terminals and output conductors of power devices 502f, 502g are similarly configured, but are not labeled explicitly in the figure. Conductors 220g, 220h and 220i may be of appropriate length to enable fast and easy coupling of each of the power devices to their respective generators, without overuse of conductive cables. For example, if PV modules 101e, 101f and 101g are of standard width (e.g., 39 inches) and are placed next to one another while oriented vertically, each output conductor may be sized in proportion to the standard width (e.g., 40-45 inches long). Power devices 502 may, in some examples, be configured electrically similar to device 102 as in installation 100a and mechanically similar to device 202.

Reference is now made to Fig. 5B, which depicts a portion of a chain of power devices coupled to photovoltaic generators in a variation of the system. PV generator 101a may include junction box 601a, to which generator cables 501a and 501b are coupled. Power generated by the PV generator (e.g., 101a) is transferred via the junction box (e.g., 601a) to the generator cables, with one cable (e.g., 501a) coupled to input terminal (e.g., 210h) of a power device (e.g., 503a), and another cable (e.g., 501b) coupled to input terminal (e.g., 210i) of an adjacent power device (e.g., 503b). Adjacent power devices (e.g., 503a and 503b) may be coupled to one another by output conductor (e.g., 220k). Power devices 503 may each include circuitry 230 (not explicitly depicted in the figure) which may comprise various elements as described herein. Output conductor 220j may couple power device 503a to an adjacent power device on one side (not shown explicitly), with input terminal 210g being coupled to an adjacent power cable (also not shown explicitly). The input terminals and output conductors of adjacent power devices (e.g., 503b, 503c, 503d) are not illustrated explicitly in the figure. Conductors 220a, 220b and 220c may be of appropriate length to enable fast and easy coupling of each of the power devices to two adjacent photovoltaic modules, without overuse of conductive cables. For example, if PV generators 101a 101b and 101c are of standard width (e.g., 39 inches) and are placed next to one another while oriented vertically, each output conductor may be of a size proportional to the standard width (e.g.,40-45 inches long). Power devices 503 may be configured electrically similar to device 103 as in installation 100b of Fig. 1B and mechanically similar to device 203.

Referring to Fig. 5C, illustrative variations may include a plurality of PV power devices 504a-c, each featuring two input terminals 106 (only labeled explicitly for power device 504a) coupled to a photovoltaic generator's junction box (e.g., 601a). The photovoltaic power may flow via the junction box and input terminals to the PV power device. The power device may include output conductor 105a, which is coupled via a T-connector to a ground bus, and output conductor 105b, which is coupled via a T-connector to a power bus. The ground bus and power bus may be coupled to the output conductors of each power device in the chain, thus coupling all the photovoltaic modules in the string in parallel. The distance between adjacent PV power devices may enable them to be coupled to adjacent PV generators in a photovoltaic installation. The power devices may be coupled to the two conductors (the ground and power buses) at the time of manufacturing, and may be compactly stored along with the conductors, enabling fast and easy deployment. Power devices 504 may be configured electrically similar to device 122 as in installation 100d and mechanically similar to device 205.

### String products

Following are further details of an integrated string of power devices. The integrated string of power devices may comprise a plurality of power devices connected together with a plurality of cables configured to electrically connect the power devices, thereby forming a string (also referred to as a chain) of power devices. The power devices at either end of the string may further be connected to an additional length of cable, e.g., having the same length or longer as the cables connected between adjacent power devices in the string. The additional lengths of cables may be unterminated at the distal end from the power converters and used for connecting the string of power devices to a central power device (e.g., a combiner box, power inverter, etc.). For example, multiple power devices are connected by repeatedly connecting (e.g., via soldering, crimping, etc.) an electrical cable between a terminal of one power device to a terminal of an adjacent power device in the string (e.g., for implementing a string illustrated in Figs. 1A-1C, IE, 2A-2C, 3, 4A, 4C, 5A, and 5B). In some variations, one or more additional cables may be connected between adjacent power device (e.g. for implementing a string as illustrated in Figs. 1D, 4B and 5C). Thus, the string of power devices will comprise a plurality of power devices arranged spatially in an order along the string with adjacent power devices in the order being permanently connected (e.g., prefabricated, designed to not be disconnected in the field during installation of the system and/or bonded by soldering or crimping) by one or more of the plurality of cables, and optionally, power devices at the ends of the order being connected to one or more unterminated cables. By combining the cables and power devices into a single apparatus, the cost of the system may decrease due to lower number of components, and the reliability of the system may increase due to few moving parts and mechanical connections. An order of power devices on a string of power devices may include a physical order of the devices, or an order of power device identification numbers or codes. The physical order is the order of the power devices as they are physically connected along a string of power devices. For example, the first power device on the string is first along the physical order.

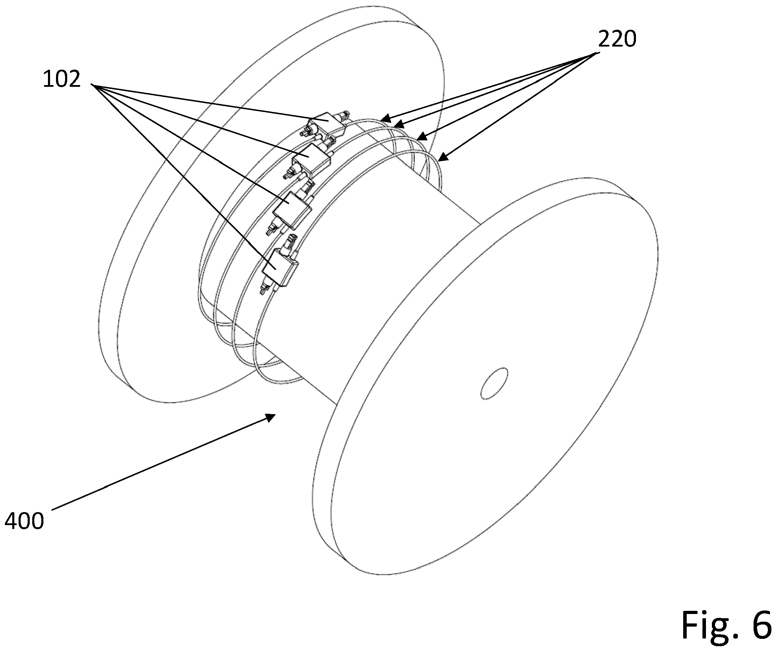

Referring now to Fig. 6, some illustrative variations include a storage device used to store a string of power devices in a way that enables convenient storing and fast and easy deployment of the chain of power devices. A chain of photovoltaic power devices may comprise PV power devices 102 coupled to one another by output conductors 220. The chain may be stored by being wound around storage device 400. In the variation depicted in Fig. 6, storage device 400 is a cylindrical reel, though other shapes may be using for winding. A cylindrical shape may make deployment easier, as a cylindrical reel may be rolled along the ground (or rotated about a spindle) in a photovoltaic installation. The storage device may be designed to allow the chain of power devices to be packaged efficiently. For example, if the storage device is similar to the cylindrical reel depicted in Fig. 6, the diameter of the reel may be chosen considering the length of the conductors coupling the power devices, so that when the chain is wound around the reel, the power devices may be located next to one another on the reel, pressed tightly together for compact storing. While Fig. 6 illustrates PV power device 102 and conductors 220, any arrangement of a string of power devices described above (e.g., as in Figs. 1A-1E, 2A-2C, 3, 4A-4C, and 5A-5C) may be packaged with storage device 400.

As noted above, a chain of power devices may further incorporate extra lengths of cable connected to the first and last power devices in the order of power devices in the chain. The extra lengths of cable may be used to connect the chain of power devices to a central power device, such as a combiner box or an inverter. The extra lengths may be connected to the inverter, for example, by soldering, crimping, welding, screw terminal, push terminal, MC4 connector, etc. For example, extra length end cables of a chain may be soldered or crimped to the input terminals of an inverter to prevent arcing, lower terminal resistance and cable losses, lower maintenance of terminals (such as regular tightening of screw terminals), and lowering the cost of the system components.

The unterminated end cables of a string of power devices may come in a variety of standard lengths, or may be customized for a particular installation. For example, strings of power devices may be manufactured having an extra 30 feet, 50 feet, 100 feet or 500 feet of unterminated end cables. As another example, a solar site design plan may be submitted to a manufacturing facility, and the manufacturing facility may manufacture prewired strings of power devices having customized wire lengths between each power device and customized end cables at each end of each string of power devices. The unterminated end cables may optionally include a connector (e.g., MC4 connector) or other connection device at the distal end from the power device.

### Mapping

An aspect of a chain of power devices may be a predetermined order of the devices. For example, a device (e.g., load, junction box, inverter) connected to a string of power devices may query device identification codes of the power devices (deviceIDs) of the string.

The device IDs may be set according to a physical order in the order of the devices along the string. For example, a physical order may be determined (e.g., during manufacturing of a string of power devices when each power device is connected to the string, or after manufacturing of the string) the identifier of the power device is recorded and associated with the particular order of that power device in the string. The recording is repeated respectively for all the power devices on a string including the first power device. From the recordings, a list is generated and stored (e.g., in a digital repository) of the identifiers and associated physical locations in the order of the power devices. The identifiers of the power devices connected to the string may be arranged to be in a sorted order according to the numerical value or alphanumerical code. For example, the identifiers may be numbers and the identifier of each added power devices is greater than the identifier of the power device previously-added power device. Similarly, the identifiers may be alphanumeric codes and the list of identifiers may be arranged according to the physical order and are also in a sorted order. For example, as the power devices are added to the string, each power device is assigned a unique identifier and that unique identifier is stored on the device, such as stored on a computer-readable, nonvolatile memory. For example, when a string of power devices is electrically connected to a central power device (for example an inverter), a processor may command the inverter to collect the identifiers of all power devices. By sorting the collected identifiers, the processor may determine the physical order of the power devices. In some examples, a look up table may be used to arrange a list of collected identifiers in the physical order along the string. For example, a look up table may convert a unique identifier to a position or location on the string, such as the distance (e.g., physical or logical) from the power device to the end of the string. For example, a look up table may convert a unique identifier to a number indicating the position on the string.

One or more of the power devices, based on the query may transmit a response that includes that power device's identification code, and optionally, additional information associated with the power device. For example, an inverter (or other connected device) may transmit a query to a plurality of power devices in a string, and one of the power devices may respond with a message including information associated the power device or power generator connected to the power device. Based on the message, the inverter (or other connected device) may transmit a notification to a technician (via a technician's device such as a smart phone) of the physical location of the power device that may need attention, such as maintenance, cleaning, replacement, etc.

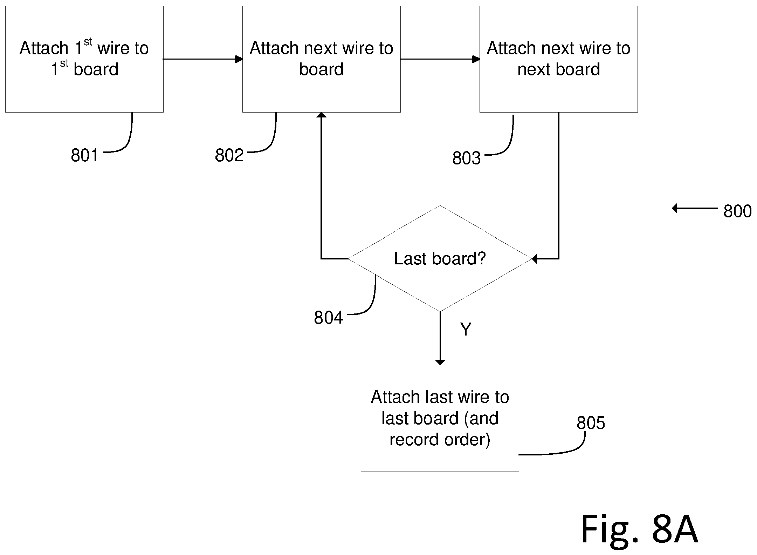

Regarding Fig. 8A, when the device string is manufactured according to flowchart 800, a first length of wire is attached to a first device board at step 801, one end of a next length of wire is attached to the first device board at step 802, and the other end of the next length of wire is attached to a next device board at step 803. When it is determined that the next device board is not the last board at step 804, the next wire is attached to the board as at step 802, and so on. When it is determined that the next device board is the last board as at step 804, a last length of wire is attached to the last device board as at step 805.

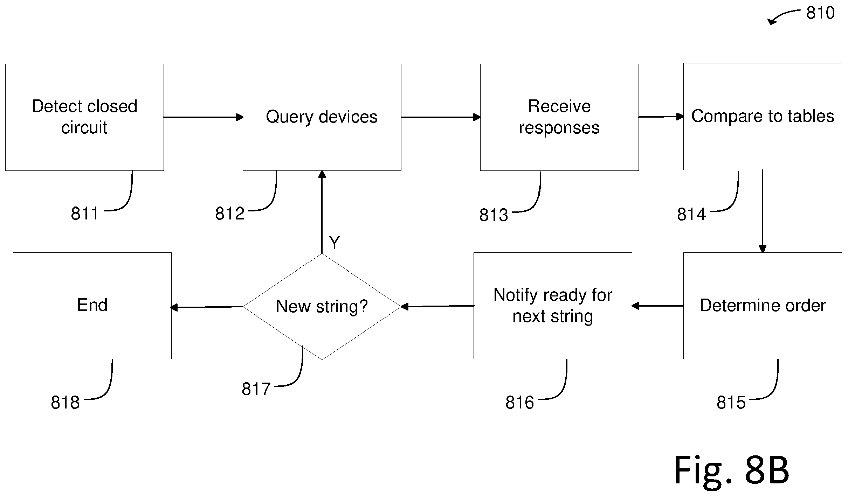

The power devices may be tested during manufacturing. The power devices may include computer logic (e.g., a microprocessor with computer-readable storage), and have a deviceID stored in the computer logic, such as in a computer nonvolatile memory, disk, repository, etc. The deviceID may be written to the device during manufacturing. The order of the deviceIDs of the power devices attached during manufacturing along the string may be recorded, and stored on a repository as at step 805, such as for later use during a system installation as in Fig. 8B.

Regarding Fig. 8B, when multiple device strings are connected in parallel to an inverter (or other system power device) as at flowchart 810, the inverter may determine the association of each device to one of the multiple strings according, for example, to the flowchart 810. For example, during installation, a system power device (e.g., an inverter, a junction box) may include multiple sensors at input terminals, where the input terminals may be configured to electrically connect with the multiple strings. When the chain of power devices is electrically connected to the power generators, the first string of power devices (including generators) is connected to the input terminals of the system power device. When the system power device detects (at step 811) a closed circuit, such as by voltage, current, and/or impedance sensors across the input terminals, the system power device may query (at step 812) the devices on the first string across the electrical connections. For example, the system power device may query each power device of the string, record a response from each device including the deviceID, and compare the deviceIDs of the responses to a list of deviceIDs retrieved from an external repository. For example, the system power device may repeated query each power device of the string, record the time each took to respond (such as in millisecond or nanosecond time resolution), and determine the order based on the response times. The query is complete once the responses are received at step 813. When the query is complete, the deviceIDs may be extracted from the responses, and these may be compared at 814 with tables of other devices connected to the system power device, such as tables of other devices and/or strings of power devices connected to the system power device. The deviceID order on the first string may be determined at step 815, for example based on the reply times determine the distance to each power device and from the distance determine the deviceIDs order. Determing the deviceID order may be based on a look-up table retrieved from an internet-connecter, computer-readable, non-transitory repository. For example, when the string is manufactured, for example, according to the flowchart 800 of Fig. 8A, the order of the power device boards may be recorded as at step 805. When the queried devices respond to queries, the responses may contain DeviceIDs which in turn may be compared to a retrieved repository. The device order of the string may be determined from the order recorded in the repository. The system power device may notify at step 816 the installer or operator to install a second string, and the process repeated. When a new string is connected to the system power device, the responses received from the query may include the deviceIDs from both the previously connected and the new strings, and the previously connected deviceIDs may be subtracted to detect the new string deviceIDs. The new string deviceIDs may be used to subsequent determine the string ordering as with any of the techniques described for the first string. For each new string connected, the string order is determined in this same manner, until no new strings are connected and the process ends as at step 818.

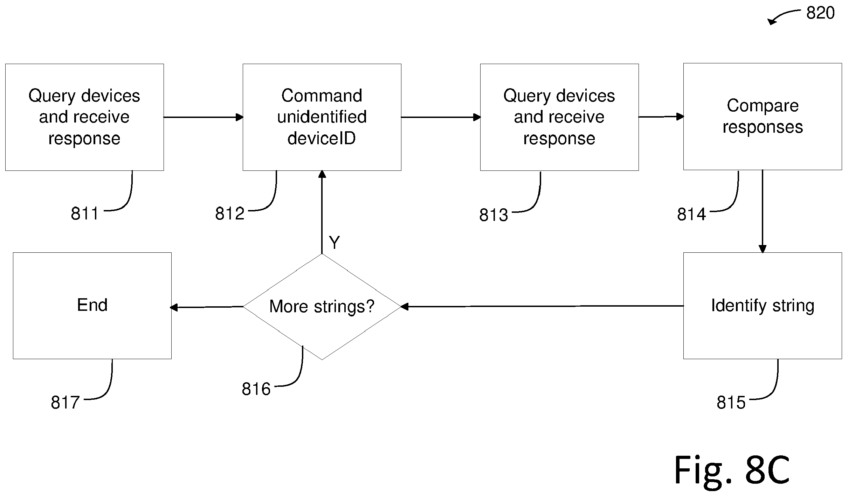

Regarding Fig. 8C, determining the association of multiple devices to one of several parallel connected strings may be performed using electrical behavior method 820 of the power devices in the strings. For example, when the complete power PV system (e.g., comprising multiple strings of power devices) is assembled, and connected to a system power device (e.g., inverter), the system power device may set a voltage or current across the parallel strings. The system power device may send a query (at step 821) to the power devices in the strings and receive (at step 821) a response from the queried devices including data, such as deviceID, device input and/or output electrical parameters, internal sensor data, external sensor data, or the like. The system power device may select a first one of the deviceIDs, and command (at step 822) that power device using the deviceID to change an electrical parameter, such as impedance, voltage, and/or current. In a response to the change of the electrical parameter, the other power devices on the same string may adjust a corresponding electrical parameter. The system power device may query (at step 823) the power devices in the strings, and receive (at step 823) new power device data, including new values for the corresponding electrical parameter from the power devices of the same string. By comparing (at step 824) the new data to the previous data (from before the electrical parameter change) the other devices on the same string as the device that was commanded may be identified (at step 825). When more unidentified deviceIDs exist (at step 826), the process may be repeated by commanding a new, unidentified deviceID, and thus the other strings may be determined using one of the methods described for the first string. When no more unidentified power devices are connected to the inverter the method ends (as at step 827).

For example, electrical determination of string association for power devices on parallel string may be performed using impedance changes to some of the devices, and injecting a voltage or current signal to the string. An electrical response to the signal may be detected based at the system power device or other power devices on the same and/or parallel strings. The electrical response in this example may be analyzed to indicate the string association and/or ordering of the devices on the parallel string, such as by a processes of elimination, measuring receipt and/or response time, etc.

### EMI

An aspect of a chain of power devices may relate to electromagnetic interference (EMI), which may include radio-frequency interference (RFI) when in the radio frequency spectrum. A disturbance generated by an external source that affects an electrical circuit by electromagnetic induction, electrostatic coupling, or conduction, may be considered EMI. For example, a disturbance may degrade the performance of a circuit or may even stop a circuit from functioning. A common problem in some PV systems is EMI leakage through the connectors. A premanufactured string of power devices manufactured without these connectors may allow better EMI protection between the power devices and other devices. For example, a PV cable (e.g., 220) may be shielded, and extend the EMI shielding to one or more power device circuits, For example, conductively connecting the EMI shield of the cable to the EMI shield of the of the power device without gaps that EMI may pass through will EMI protect the circuits and cable. By continuing the EMI shield connections between cable EMI shields and power device EMI shields, the power device circuits of the string of power devices is EMI protected.

A string device may be configured with electrical connections (for example, soldered or crimped connections) between the cables and power device boards that reduce EMI leakage out from the cable or power device. For example, a shielded cable soldered to the printed circuit board (PCB) of the power device may better protect the cable and power devices from external EMI entering the power device interior cavity by making the continuity of the EMI shield extend as much as possible around the power conducting wires and circuits. Similar examples may use crimping, adhesion, clamping, or the like to form and EMI-leakage-preventing seal between the EMI cable shield and the EMI power device shield. For example, a shielded cable may connect electrically or connect conductively to power device to prevent EMI leakage between the two shields. For example, when the power device has an EMI shield (which may be incorporated into a housing for example) the cable shield may be electrically (conductively) connected to the device EMI shield. The EMI shield may be isolated or connected to ground, such as using a single point.

As disclosed herein, the shields of the cables and power devices of a string may be electrically or conductively connected together as much as feasible. For example, the cables and power device shields may be connected by soldering, crimping, coupling, connecting, clamping, etc. Optionally, one or more shields of the cables and/or power devices may be connected at one end or the other end to a ground reference, such as an earth ground, a return line, a power line, and/or ground of the system power device (e.g., the casing of the inverter, which is tied to, for example, earth ground.)

### Extra wire(s)

The cables between the power devices along the chain may comprise one or more additional conductors mechanically connected to the power electrical conductor, such as small gauge, low-current conductors. For example, EMI shielding may be used as a single wire conductor as it may form a continuous conductor across all power devices of the chain. The one or more additional conductors may be used to assist with sensing and/or mapping between the power devices. The one or more extra conductors may be used for communication between the power devices or between the power devices and a central power device. For example, a single wire may be used for communication using a single switch that sets the wire to a constant voltage when closed, and when the switch is open a zero or non-constant voltage is measured on the wire. For example, the additional conductor can be used as a voltage reference for measuring the voltage of the output terminals of the power devices along the string. For example, the additional conductor is connected to each power device using a switch, and each power device also has a voltage sensor to measure the voltage of the extra wire with reference to another of the power devices. For example, an 8-wire Ethernet cable may be embedded in the electrical cable between the power devices. For example, a series of sensors may be positioned along the wire and/or at each power device, and the sensors may measure electrical parameters of the power devices, cable, system, etc.

### Spare devices

An aspect of a chain of power devices may be utilization of one or more spare power devices either preplanned and incorporated into the string apparatus or integrated into the installation method using a special hardware connector. The hardware connector may be a shielded PV cable with connectors at the ends. The cable may be configured so that the input sides of the power device are physically covered and electrically disconnected. When one of the devices of the chain malfunctions, the power devices may be shifted so that the malfunctioning device is disconnected from the associated first panel, the power device from the next panel is shifted to the first panel, and so on, repeatedly, until the last panel, where the spare power device is used. In this way, spare power devices located at the ends of the chain may be used to replace malfunctioning power devices connected to the PV panels.

A spare power device incorporated into the string of power devices may be connected to a PV panel to replace a malfunction power device using electrical cables connecting the PV panel and the spare power device. For example, a malfunctioning power device may be disconnected from the associated PV panel, and extension cables connected to the PV panel cables so that the PV panel is electrically connected to a spare power device at an end of the chain of power devices. One or more spare power devices may be incorporated into the chain of power devices, so that there are spare power devices in the case of malfunction of one or more of the power devices. For example, shifting the power devices, or using extension cables from the spare power device to the PV panel, allows repair of the malfunctioning power device without replacing the chain of power devices.

One or more connectors may be incorporated along the chain of power devices, such as MC4 connectors, such that a connector is positioned along the chain every certain number of power devices, thereby forming a subset of power devices between connectors. For example, an MC4 connector is positioned along the cable between every 5^{th} power device. The number of power devices between connecter may be between 2 and 100, depending on the requirements and system capacity. The connectors may allow easy maintenance when one or more power devices malfunctions, by allowing to replace the subset of power devices, rather than replacing the complete chain or manually soldering one or more replacement power devices instead of the malfunctioning ones.

Reference is now made to Fig. 7A, which depicts illustrative aspects of a string of power devices coupled by conductors with prefabricated (e.g., permanent connections, such as soldered connections). A system for power generation 700 may comprise a central power device 110E. Central power device 110E may be electrically connected to a power network including shielded conductors between power devices, where each conductor includes an EMI shield incorporated into the casing of the conductor. End cables 710H and 711H, also including an EMI-shielded conductor, connect between central power device 110E and power busses 710E (low voltage or return bus) and 711E (high voltage bus). One or more chains of power devices 316a... 316n, comprising EMI-shielded conductors between the power devices, may be connected between low-voltage bus 710E and high-voltage bus 711E. By way of example, power device chain 316a may be configured as installation 100a of Fig. 1A and power device chain 316n may be configured as installation 100b of Fig. 1B, but the electrical configuration of other chains may conform to other installations, as 100d, 100e, or the like. Power device chains 316a...316n may comprise a series of power devices, such as 109a, 109b, 109c, etc., up to 109t in the examples of Fig. 7A. Each of power devices 109a, 109b, 109c, etc., up to 109t may be connected to a PV panel 101a, 101b, 101c, ... up to 101t. Each power device 109a, 109b, 109c, etc., up to 109t may comprise an identification number or code, and the identification number or code may be used to determine the order of the power devices along the chain of power devices, as described herein. While the devices, generators and strings are designated with specific ranges of lower case suffixes (e.g., a through n, a through j, k through t), the number of devices, generators, and strings are not limited to these ranges and may include any number of elements.

Power device chains 316a...316n may include one or more connector pairs, such as interconnections, as at 701A/B and 701C/D. A chain of power devices, as at 316a...316n, may comprise interconnections (e.g., connectors), such as 701A/B and 701C/D, to allow replacement of a portion of the power device chain. For example, connectors are located between power device 109 and each PV generator 101. When a specific device fails, the connecters are used to disengage the failed power device from the panel, and the power devices between the failed one and the spare one are shifted one panel over. After the shift of power devices the failed device is now a spare device and the spare device is connected to the closest panel.

Interconnections may be incorporated into selected conductors between the power devices along the chain, such as one interconnection every other conductor, every third conductor, every fourth conductor, every fifth conductor, etc. For example, an interconnection is incorporated into one conductor out of a group of sequential power devices, such as a group of power devices that number between 2 and 20 power devices, allowing easy replacement of a portion of the chain containing the failed power device.

Power device chains 316a... 316n may include one or more spare power devices as at 109d, 109k, and 109o. A spare device in the middle or the end of a chain of power devices may be used to replace a malfunctioning power device. For example, by swapping positions of the power devices along the chain, a spare power device may replace the operation of a malfunctioning power device. For example, when power device 1091 malfunctions, PV panel 1011 may be connected to spare power device 109k. For example, separate cables may be used to connect the PV panel of the malfunctioning power device to the spare power device. For example, when power device 109m malfunctions, PV panel 101m may be connected to spare power device 109k using extra conductors the may run from the PV panel 101m to power device 109k.

Reference is now made to Fig. 7B, which depicts illustrative aspects of the internal features of a power device 109x from a string of power devices coupled by conductors with permanent connections. The power device of Fig. 7B is an example device comprising the common features of power devices 109a... 109t (or any of the power devices discussed herein), and as such is designated 109x where the x may be replaced by a... t to designate any of the power devices of Fig. 7A. PCB 706x comprises an identification code 725 (e.g., a unique identifier) which uniquely identifies the power device in the chain of power devices, and may be used to determine the order of the power devices in the chain. The unique identifiers may be based on a look-up table (LUT) stored on a computer-readable non-transitory repository. The unique identifiers and the LUT may be retrieved by a processor associated with the string of power devices. The processor may determine the order based on the plurality of unique identifiers and the LUT. For example, the LUT contains a list of unique identifiers in a first column and in the second column a value representing the rank of the device (with each unique identifier) in the physical ordering.

Power device 109x comprises an EMI shield 702 encompassing a printed circuit board 706x (PCB). EMI shield 702 may form a continuous or partial EMI barrier with EMI shields 704a and 704b of the conductors 703a and 703b. For example, EMI shield 702 may be joined to cable EMI shield 704b using a material or process that is configured to preserve the continuity of the EMI shields. For example, EMI shields 702 and 704b may be joined using an at least partially conducting joining material 705b and 705c, such as solder, a conducting adhesive, a conducting polymer, etc. Similarly, conductor 703b may be electrically connected to PCB 706x using solder 705a. Similarly, Connectors 707x and 708x may be electrically connected to PCB 706x using solder 705d and 705e respectively. Similarly to the connection between cable EMI shield 704b, EMI shield 704a may be connected to EMI shield 702 using a material or process 705f and 705g that is configured to preserve the continuity of the EMI shields, such as welding, solder, conducting adhesive, etc. Similar to conductor 703b, conductor 703a may be electrically connected to PCB 706x using solder 705h (or other connection device such a crimp, or screw).

Reference is now made to Fig. 7C, which depicts illustrative aspects of intermittent terminal connectors along a string of photovoltaic power devices coupled by conductors with permanent connections. For example, a chain of power devices is coupled with interleaved permanently connected (e.g., soldered, crimped, etc.) conductors, and every 5 conductors along the chain comprises a terminal connector 701A and 701B between power devices 109x and 109x+1. When a power device malfunctions, the sub-string of power devices comprising the malfunctioning power device may be replaced by disconnecting the connectors at each end, removing the substring comprising the faulty power device, and connecting a new substring of power devices. Similarly, a terminal connector may be included in one of every X power devices, where X, for example, may be a number of devices between 2 and 10 power devices.

In some variations, an apparatus includes a plurality of power devices and a plurality of photovoltaic generators connected to the power devices. The power devices may include an input terminal, a common terminal and first and second output terminals. An input terminal of a first power device may be connected to a first power source terminal of one of the plurality of photovoltaic generators, a first output terminal of a second power device may be connected to a second power source terminal of one of the plurality of photovoltaic generators, and a second output terminal of the second power device may be connected to a common terminal of the first power device. The first and second output terminals may output a common output voltage, with a total output current flowing through the power device (e.g. a photovoltaic string current where the power device is part of a photovoltaic string) being divided between a first output current flowing through the first output terminal and a second output current flowing through the second output terminal. The first output current may further flow through a connected photovoltaic generator, and in some variations, the power device may be operated to provide a first output current corresponding to a Maximum Power Point current of the photovoltaic generator. The power device may be operated to provide a second output current corresponding to a differential current between the total output current and the first output current.

In some variations, the first output terminal may comprise a connector designed to be connected to a photovoltaic generator terminal, for example, using an MC4^{™} connector. In some variations, the second output terminal and the common terminal may comprise conductors preconnected to the power device and other power devices (e.g. conductors 220c and 220d of Fig. 2A, or conductors 220a and 220b of Fig. 2B). Dividing the current of a power device into two or more portions may create smaller current portions that allow for cables which may be thinner and cheaper than those which would otherwise be needed.

At least one of the power devices may include a combiner box configured to couple to a plurality of photovoltaic strings and to combine power from the plurality of photovoltaic strings. One or more power devices may include one or more sensors or sensor interfaces configured to measure or to receive measurements of one or more parameters associated with the plurality of photovoltaic generators. One or more power devices may include one or more safety switches configured to disconnect and/or short circuit the photovoltaic generators upon detection of a predefined potentially unsafe condition or in response to a manual trigger. The manual trigger may include activation of a rapid-shutdown switch or button.

In some variations, the power device may include output conductors configured to transmit and/or receive PLC signals. A communications link (e.g. may be integrated with output conductors and may be communicatively coupled to a communication device. A thermal sensor device may be integrated with output conductors and may provide temperature measurements to a control device associated with the apparatus. The thermal sensor device may include a thermocouple device and/or a linear heat detector. Temperature measurements by the thermal sensor device may be obtained at one or more locations along the output conductors.

In some variations, an apparatus includes a plurality of power devices and a plurality of conductors connecting, each connecting one power device to at least one other power device. A first conductor may be connected between an input of a first power device and a first output of a first power generator. A second conductor may be connected between an output of the first power device and a second output of first power generator. A third conductor may be connected between an output of a second power device and the common terminal of the first power device. The conductors may be internally connected to circuitry inside a respective power device. At least one of the plurality of conductors may, at a first end, be soldered or connected via a screw to the power device. A second end of the conductor may be soldered or connected via a screw to another power device. Specifically, the first end and second end may each be connected to a power converter or monitoring device in a respective power device.

Other variations may consider alternative storage techniques, such as packing power device chains into boxes, winding the chain around multiple poles, and the like.

Although selected variations of the present invention have been shown and described, it is to be understood the present invention is not limited to the described variations. Instead, it is to be appreciated that changes may be made to these variations without departing from the principles and spirit of the invention, the scope of which is defined by the claims and the equivalents thereof. Further, elements of each variation may be combined with elements from other variations in appropriate combinations or subcombinations. For example, conductors 234a-b of Fig. 4C may be located at a same side of lid 232, similarly to as shown with regard to terminals 210c and 210d of Fig. 2A. As another example, a chain of power devices may connect a plurality of photovoltaic generators in parallel, as shown in Fig. 5C, wherein each of the plurality of photovoltaic generators comprises a plurality of serially connected photovoltaic panels (as shown in Fig. IE) or photovoltaic cells.

In illustrative variations disclosed herein, photovoltaic generators are used as examples of power sources which may make use of the novel features disclosed. Each PV generator may comprise one or more solar cells, one or more solar cell strings, one or more solar panels, one or more solar shingles, or combinations thereof. In some variations, the power sources may include batteries, flywheels, wind or hydroelectric turbines, fuel cells or other energy sources in addition to or instead of photovoltaic panels. Systems, apparatuses and methods disclosed herein which use PV generators may be equally applicable to alternative systems using additional power sources, and these alternative systems are included in variations disclosed herein.

The present application also discloses the subject matter in the following clauses:
Clause 1: An apparatus, comprising:
   a plurality of power devices arranged in a physical order, each power device of the plurality of power devices comprising:
      an electrical circuit,
      at least one power input terminal configured to receive electrical power, and a unique identifier of a plurality of unique identifiers; and
   a plurality of electrical cables,
   wherein the electrical circuits of each adjacent pair of the power devices along the physical order are permanently connected by a different one of the plurality of electrical cables, and wherein the plurality of unique identifiers indicates the physical order of the plurality of power devices.
Clause 2: The apparatus of clause 1, wherein a sequential order of the plurality of unique identifiers identifies the physical order of the plurality of power devices.
Clause 3: The apparatus of clause 1, further comprising a computer-readable non-transitory repository, wherein the physical order is identified by a look-up table (LUT) stored in the computer-readable non-transitory repository.
Clause 4: The apparatus of any preceding clause, wherein each power device of the plurality of power devices comprises a device electromagnetic interference (EMI) shield, wherein each electrical cable of the plurality of electrical cables comprises a cable EMI shield, and wherein the device EMI shields of each adjacent pair of power devices along the physical order are permanently connected by the cable EMI shield of the different one of the plurality of electrical cables.
Clause 5: The apparatus of any preceding clause, further comprising:
   a plurality of second power devices arranged in a second physical order;
   a plurality of second electrical cables, wherein each adjacent pair of the second power devices along the second physical order are permanently connected by a different one of the plurality of second electrical cables; and
   an end cable comprising a male connector and a female connector mated together, wherein one of the plurality of power devices at an end of the physical order is connected through the end cable to one of the plurality of second power devices at an end of the second physical order.
Clause 6: An apparatus, comprising:
   a plurality of power devices arranged in a physical order, each power device of the plurality of power devices comprising:
      an electrical circuit,
      at least one power input terminal configured to receive electrical power
   from at least one power generator, and
      a device electromagnetic interference (EMI) shield at least partially encompassing the electrical circuit; and
   a plurality of electrical cables, wherein each electrical cable of the plurality of electrical cables comprises a conductor and a cable EMI shield,
   wherein the electrical circuits and device EMI shields of each adjacent pair of the power devices along the physical order are permanently connected by the conductor and the cable EMI shield, respectively, of a different one of the plurality of electrical cables.
Clause 7: The apparatus of clause 6, wherein each power device of the plurality of power devices comprises a unique identifier of a plurality of unique identifiers, and wherein the plurality of unique identifiers indicates the physical order of the plurality of power devices.
Clause 8: The apparatus of clause 6, wherein each power device of the plurality of power devices comprises a unique identifier of a plurality of unique identifiers, and wherein a sequential order of the plurality of unique identifiers indicates the physical order of the plurality of power devices.
Clause 9: The apparatus of clause 6, further comprising a computer-readable non-transitory repository, wherein each power device of the plurality of power devices comprises a unique identifier of a plurality of unique identifiers, and wherein the physical order is identified by a LUT of the plurality of unique identifiers stored in the computer-readable non-transitory repository.
Clause 10: The apparatus of any of clauses 6-9, further comprising:
   a plurality of second power devices arranged in a second physical order;
   a plurality of second electrical cables, wherein each adjacent pair of the second power devices along the second physical order are permanently connected by a different one of the plurality of second electrical cables; and
   an end cable, comprising a male connector and a female connector mated together, wherein one of the plurality of power devices at an end of the physical order is connected through the end cable to one of the plurality of second power devices at an end of the second physical order.
Clause 11: A method comprising:
   retrieving, by a processor from a plurality of power devices, a plurality of unique identifiers, each unique identifier being retrieved from a respective one of the plurality of power devices, wherein the plurality of power devices are permanently connected together with a plurality of electrical cables interleaved between the plurality of power devices;
   determining a physical order of the plurality of power devices, based on the plurality of unique identifiers; and
   storing the physical order on a computer-readable non-transitory memory.
Clause 12: The method of clause 11, further comprising retrieving a LUT of the plurality of unique identifiers stored on the computer-readable non-transitory memory, wherein the determining of the physical order is further based on the LUT.
Clause 13: The method of clause 11, wherein the determining of the physical order is further based on sorting the plurality of unique identifiers.
Clause 14: The method of any of clauses 11-13, wherein each power device of the plurality of power devices comprises: an electrical circuit, and at least one power input terminal configured to receive electrical power from at least one power generator, wherein the plurality of unique identifiers are retrieved from the electrical circuits of the plurality of power devices.
Clause 15: The method of any of clauses 11-13, wherein each power device of the plurality of power devices comprises an electrical circuit, wherein the plurality of unique identifiers are retrieved from the electrical circuits of the plurality of power devices.
Clause 16: The method of any of clauses 11-15, wherein each power device of the plurality of power devices comprises at least one power input terminal, and wherein the method further comprises receiving power input from at least one power generator.
Clause 17: A system comprising:
   a plurality of power devices arranged in a physical order, each power device of the plurality of power devices comprising an electrical circuit, a unique identifier of a plurality of unique identifiers, and at least one power input terminal configured to electrically connect to at least one power generator; and
   a plurality of electrical cables, wherein each pair of electrical circuits of adjacent power devices of the plurality of devices along the physical order are permanently connected by a different one of the plurality of electrical cables, and wherein the plurality of unique identifiers identifies the physical order of the plurality of power devices.
Clause 18: The system of clause 17, wherein a sequential order of the plurality of unique identifiers identifies the physical order of the plurality of power devices.
Clause 19: The system of clause 17, further comprising a computer-readable non-transitory repository, wherein the physical order is identified by a LUT of the plurality of unique identifiers stored in the computer-readable non-transitory repository.
Clause 20: The system of any of clauses 17-19, wherein each power device of the plurality of power devices comprises a device electromagnetic interference (EMI) shield, wherein each electrical cable of the plurality of electrical cables comprises a cable EMI shield, and wherein the device EMI shields of each adjacent pair of power devices along the physical order are permanently connected by the cable EMI shield of the different one of the plurality of electrical cables.
Clause 21: The system of any of clauses 17-20, further comprising:
   a plurality of second power devices arranged in a second physical order;
   a plurality of second electrical cables, wherein each adjacent pair of the second power devices along the second physical order are permanently connected by a different one of the plurality of second electrical cables; and
   an end cable comprising a male connector and a female connector mated together, wherein one of the plurality of power devices at an end of the physical order is connected through the end cable to one of the plurality of second power devices at an end of the second physical order.
Clause 22: A system comprising:
   a plurality of power devices arranged in a physical order, each power device of the plurality of power devices comprising an electrical circuit, a device EMI shield encompassing the electrical circuit, and at least one power input terminal configured to receive electrical power from at least one power generator; and
   a plurality of electrical cables, wherein each electrical cable of the plurality of electrical cables comprises a cable EMI shield;
   wherein each pair of electrical circuits of adjacent power devices of the plurality of devices along the physical order are permanently connected by a different one of the plurality of electrical cables, and
   wherein the device EMI shields of each adjacent pair of power devices are electrically connected to the cable EMI shield of the different one of the plurality of electrical cables.
Clause 23: The system of clause 22, wherein each power device of the plurality of power devices comprises a unique identifier of a plurality of unique identifiers, and wherein the plurality of unique identifiers indicates the physical order of the plurality of power devices.
Clause 24: The system of clause 22, wherein each power device of the plurality of power devices comprises a unique identifier of a plurality of unique identifiers, and wherein a sequential order of the plurality of unique identifiers indicates the physical order of the plurality of power devices.
Clause 25: The system of clause 22, further comprising a computer-readable non-transitory repository, wherein each power device of the plurality of power devices comprises a unique identifier of a plurality of unique identifiers, and wherein the physical order is identified by a LUT of the plurality of unique identifiers stored in the computer-readable non-transitory repository.
Clause 26: The system of any of clauses 22-25, further comprising:
   a plurality of second power devices arranged in a second physical order;
   a plurality of second electrical cables, wherein each adjacent pair of the second power devices along the second physical order are permanently connected by a different one of the plurality of second electrical cables; and
   an end cable, comprising a male connector and a female connector mated together, wherein one of the plurality of power devices at an end of the physical order is connected through the end cable to one of the plurality of second power devices at an end of the second physical order.
Clause 27: A system comprising:
   a plurality of power generators; and
   a string of power devices comprising:
      a plurality of power devices arranged in a physical order, each power device of the plurality of power devices comprising an electrical circuit, a unique identifier of a plurality of unique identifiers, and at least one power input terminal configured to receive electrical power from at least one power generator of the plurality of power generators, and
      a plurality of electrical cables, wherein the electrical circuits of each adjacent pair of power devices along the physical order are permanently connected by a different one of the plurality of electrical cables, wherein the plurality of unique identifiers identifies the physical order of the plurality of power devices, and wherein a quantity of the at least one power input terminal of the plurality of power devices is greater than a quantity of the plurality of power generators.
Clause 28: The system of clause 27, wherein a sequential order of the plurality of unique identifiers identifies the physical order of the plurality of power devices.
Clause 29: The system of clause 27, further comprising a computer-readable non-transitory repository, wherein the physical order is identified by a LUT of the plurality of unique identifiers stored in the computer-readable non-transitory repository.
Clause 30: The system of any of clauses 27-29, wherein each power device of the plurality of power devices comprises a device electromagnetic interference (EMI) shield, wherein each electrical cable of the plurality of electrical cables comprises a cable EMI shield, and wherein the device EMI shields of each adjacent pair of power devices along the physical order are permanently connected by the cable EMI shield of the different one of the plurality of electrical cables.
Clause 31: The system of any of clauses 27-30, further comprising:
   a plurality of second power devices arranged in a second physical order;
   a plurality of second electrical cables, wherein each adjacent pair of the second power devices along the second physical order are permanently connected by a different one of the plurality of second electrical cables; and
   an end cable comprising a male connector and a female connector mated together, wherein one of the plurality of power devices at an end of the physical order is connected through the end cable to one of the plurality of second power devices at an end of the second physical order.

## Claims

1. An apparatus, comprising:
a plurality of power devices arranged in a physical order, each power device of the plurality of power devices comprising:
an electrical circuit,
at least one power input terminal configured to receive electrical power, and
a unique identifier of a plurality of unique identifiers; and
a plurality of electrical cables,
wherein the electrical circuits of each adjacent pair of the power devices along the physical order are permanently connected by a different one of the plurality of electrical cables, and wherein the plurality of unique identifiers indicates the physical order of the plurality of power devices.

2. The apparatus of claim 1, wherein a sequential order of the plurality of unique identifiers identifies the physical order of the plurality of power devices.

3. The apparatus of claim 1, further comprising a computer-readable non-transitory repository, wherein the physical order is identified by a look-up table (LUT) of the plurality of unique identifiers stored in the computer-readable non-transitory repository.

4. The apparatus of any preceding claim, wherein each power device of the plurality of power devices comprises a device electromagnetic interference (EMI) shield, wherein each electrical cable of the plurality of electrical cables comprises a cable EMI shield, and wherein the device EMI shields of each adjacent pair of power devices along the physical order are permanently connected by the cable EMI shield of the different one of the plurality of electrical cables.

5. The apparatus of any preceding claim, further comprising:
a plurality of second power devices arranged in a second physical order;
a plurality of second electrical cables, wherein each adjacent pair of the second power devices along the second physical order are permanently connected by a different one of the plurality of second electrical cables; and
an end cable comprising a male connector and a female connector mated together, wherein one of the plurality of power devices at an end of the physical order is connected through the end cable to one of the plurality of second power devices at an end of the second physical order.

6. A method comprising:
retrieving, by a processor from a plurality of power devices, a plurality of unique identifiers, each unique identifier being retrieved from a respective one of the plurality of power devices, wherein the plurality of power devices are permanently connected together with a plurality of electrical cables interleaved between the plurality of power devices;
determining a physical order of the plurality of power devices, based on the plurality of unique identifiers; and
storing the physical order on a computer-readable non-transitory memory.

7. The method of claim 6, further comprising retrieving a LUT of the plurality of unique identifiers stored on the computer-readable non-transitory memory, wherein the determining of the physical order is further based on the LUT.

8. The method of claim 6, wherein the determining of the physical order is further based on sorting the plurality of unique identifiers.

9. The method of claim 6, wherein each power device of the plurality of power devices comprises: an electrical circuit, and at least one power input terminal configured to receive electrical power from at least one power generator, wherein the plurality of unique identifiers are retrieved from the electrical circuits of the plurality of power devices.

10. The method of claim 6, wherein each power device of the plurality of power devices comprises an electrical circuit, wherein the plurality of unique identifiers are retrieved from the electrical circuits of the plurality of power devices.

11. The method of any of claims 6-10, wherein each power device of the plurality of power devices comprises at least one power input terminal, and wherein the method further comprises receiving power input from at least one power generator.

12. A system comprising:
a plurality of power devices arranged in a physical order, each power device of the plurality of power devices comprising an electrical circuit, a unique identifier of a plurality of unique identifiers, and at least one power input terminal configured to electrically connect to at least one power generator; and
a plurality of electrical cables, wherein each pair of electrical circuits of adjacent power devices of the plurality of devices along the physical order are permanently connected by a different one of the plurality of electrical cables, and wherein the plurality of unique identifiers identifies the physical order of the plurality of power devices.

13. The system of claim 12, wherein a sequential order of the plurality of unique identifiers identifies the physical order of the plurality of power devices.

14. The system of claim 12, further comprising a computer-readable non-transitory repository, wherein the physical order is identified by a LUT of the plurality of unique identifiers stored in the computer-readable non-transitory repository.

15. The system of any of claims 12-14, wherein each power device of the plurality of power devices comprises a device electromagnetic interference (EMI) shield, wherein each electrical cable of the plurality of electrical cables comprises a cable EMI shield, and wherein the device EMI shields of each adjacent pair of power devices along the physical order are permanently connected by the cable EMI shield of the different one of the plurality of electrical cables.
